# EUROPÄISCHE PATENTSCHRIFT

(11) **EP 2 706 363 B1**
(45) Veröffentlichungstag und Bekanntmachung des Hinweises auf die Patenterteilung: **07.07.2021**
(21) Anmeldenummer: 13180680.4
(22) Anmeldetag: 16.08.2013
(51) Int. Cl.: G01R 13/02, G01R 19/04, G06T 11/20

(54) **Linie zur Markierung von gemeinsamen Zeitpunkten**
Line for marking common points in time
Ligne de marquage des points temporels communs

(30) Priorität: 10.09.2012 DE 102012215966; 30.07.2013 DE 102013214819
(43) Veröffentlichungstag der Anmeldung: 12.03.2014
(73) Patentinhaber: Rohde & Schwarz GmbH & Co. KG, 81671 München (DE)
(72) Erfinder: Lang, Florian, 82205 Gilching (DE)
(74) Vertreter: Körfer, Thomas

(56) Entgegenhaltungen:
- US-A- 5 898 307
- US-A1- 2004 034 500
- US-B1- 6 681 191
- DAVID A HUMPHREYS ET AL: "Traceable measurement of Error Vector Magnitude (EVM) in WCDMA signals", WAVEFORM DIVERSITY AND DESIGN CONFERENCE, 2007. INTERNATIONAL, IEEE, PI, 1. Juni 2007 (2007-06-01), Seiten 270-274, XP031139540, ISBN: 978-1-4244-1275-4

## Beschreibung

Die Erfindung betrifft ein Messgerät und ein Verfahren zur zeitlich synchronen Darstellung und Markierung von gemeinsamen Zeitpunkten eines digitalisierten und gespeicherten ersten Teilsignals und zumindest eines digitalisierten und gespeicherten zweiten Teilsignals eines Multibandsignals.

Große Bedeutung hat heutzutage die genaue Analyse von Multibandsignalen erlangt. Unter Multibandsignalen wird im Rahmen dieser Beschreibung ein Signal einer Multibandbasisstation mit mehreren Trägern und unterschiedlichen Mobilfunkstandarts verstanden. Bei einer Basisstation für Multibandsignale muss beispielsweise untersucht werden, ob Ereignisse wie z.B. steile Flanken in einem Band Auswirkungen auf die Signalqualität des nebenliegenden Bandes haben. Hier ist es für den Benutzer besonders problematisch, den zeitlichen Zusammenhang zwischen den beiden Bändern herzustellen.

Aus der DE 32 24 836 C2 ist eine Einrichtung zur Anzeige von Wellenformen bekannt, die beispielsweise zwei verschiede Signale seitlich synchron zueinander in verschiedene Speicherbereiche schreibt. Dabei kann ein Signal auf der dazugehörigen Anzeigevorrichtung mit zwei verschiedenen Zeitachsen dargestellt werden, wobei ein Marker die Zeitpunkte in den beiden Darstellungen markiert, die den gleichen Zeitpunkt darstellen. Nachteilig an der DE 32 24 836 C2 ist, dass die Art und Weise, wie das Signal dargestellt wird, einen Benutzer nur schwer einen Fehler innerhalb des Signals entdecken lässt. Gezeigt wird jedoch keine Verarbeitung von Multibandsignalen.

Aus dem Dokument US 2003/0163266 A1 geht ebenfalls ein Messgerät hervor, welches synchrone Markierungen in verschiedenen Darstellungen anzeigt. Auch dieses Messgerät ist jedoch nicht in der Lage Multibandsignale zu verarbeiten.

Auch das Dokument US 2008/0259082 A1 zeigt ein Messgerät, welches synchrone Markierungen in verschiedenen Darstellungen zeigt. Auch mit diesem Messgerät können jedoch keine Multibandsignale verarbeitet werden. Aus dem Dokument "ANRITSU Corporation: Practical Tips on WCDMA Measurements, Application Note No. 11410-00378, Sept. 2008" sind Messgeräte bekannt, welche unterschiedliche Darstellungen eines Signals in verschiedenen Fenstern ermöglichen.

Das Dokument US 2004/034500 A1 zeigt ein Messgerät, welches jeweils in einem eigenen Anzeigefenster eines von zwei unterschiedlichen Messsignalen darstellt. Dieses Dokument zeigt weiterhin die Anzeige einer Marker-Linie in den beiden Anzeigefenstern. Diese Marker-Linie kann von einem Nutzer an einer zeitlichen Position seiner Wahl positioniert werden. Wenn der Nutzer die Marker-Linie in einem der Anzeigefenster positioniert, wird sie in dem zweiten Anzeigefenster automatisch auf dieselbe zeitliche Position verschoben.

Es ist daher die Aufgabe des erfindungsgemäßen Messgeräts und des erfindungsgemäßen Verfahrens, eine Lösung zu schaffen, damit ein Benutzer möglichst schnell einen Fehler innerhalb eines Multibandsignals entdecken kann. Die Aufgabe wird bezüglich des Messgeräts durch die Merkmale des Anspruchs 1 und bezüglich des Verfahrens durch die Merkmale des Anspruchs 9 gelöst. Der Anspruch 16 beinhaltet ein Computerprogramm mit Programmcode-Mitteln, um sämtliche Verfahrensschritte ausführen zu können, wenn das Programm auf einem Computer oder einem digitalen Signalprozessor ausgeführt wird. Der Anspruch 17 enthält ein Computerprogramm-Produkt mit auf einen maschinenlesbaren Träger gespeicherten Programmcode-Mitteln, um alle Verfahrensschritte durchführen zu können, wenn das Programm auf einen Computer oder einem digitalen Signalprozessor ausgeführt wird. In den jeweiligen Unteransprüchen sind vorteilhafte Weiterbildungen des erfindungsgemäßen Messgeräts und des erfindungsgemäßen Verfahrens angegeben.

Das erfindungsgemäße Messgerät weist eine Speichereinheit, eine Verarbeitungseinheit und eine Anzeigevorrichtung auf und dient zur Darstellung eines digitalisierten und gespeicherten ersten Teilsignals und zumindest eines digitalisierten und gespeicherten zweiten Teilsignals . Das erste Teilsignal und das zweite Teilsignal sind dabei Teilsignale unterschiedlicher Bänder des Multibandsignals. Die Verarbeitungseinheit ist dabei ausgebildet, um ein von dem ersten Teilsignal abgeleitetes erstes Signal und eine erste Analyselinie in einem ersten Fenster auf der Anzeigevorrichtung darzustellen, und um ein von dem zweiten Teilsignal abgeleitetes zweites Signal und eine zeitlich der ersten Analyselinie des ersten Fensters entsprechende erste Analyselinie in einem zweiten Fenster auf der Anzeigevorrichtung darzustellen. So ist es für einen Nutzer möglich, sehr einfach und übersichtlich Fehlerursachen in den verschiedenen Teilsignalen zu ermitteln.

Die Verarbeitungseinheit berechnet von dem ersten Teilsignal den Verlauf eines Fehler-Werts über einen bestimmten Zeitraum und stellt diesen in einem ersten Fenster auf der Anzeigevorrichtung dar. Im Weiteren setzt die Verarbeitungseinheit in dem ersten Fenster eine erste Analyselinie auf dem Zeitpunkt, an dem der Verlauf des Fehler-Werts einen durch die Verarbeitungseinheit aus einer Speichereinheit geladenen Schwellwert überschreitet. Es ist besonders vorteilhaft, dass das Messgerät die verschiedenen Teilsignale eines Multibandsignals analysieren kann, wobei das Messgerät von einem ersten Teilsignal einen Verlauf eines Fehler-Werts über einen bestimmten Zeitraum berechnet. Bei dem bestimmten Zeitraum handelt es sich um einen einstellbaren Zeitraum, der vorzugsweise die Länge eines Frames (dt. Rahmen) hat. Die Verarbeitungseinheit kann dabei die Fehler-Werte mit einem in einer Speichereinheit gespeicherten Schwellwert vergleichen und eine Analyselinie auf den Zeitpunkt setzen, an dem der Fehler-Wert den in der Speichereinheit gespeicherten Schwellwert überschreitet. Dies erlaubt es dem Benutzer, sofort diesen Zeitpunkt innerhalb des Verlaufs des Fehler-Werts zu sehen.

Das erfindungsgemäße Verfahren dient zur Darstellung eines digitalisierten und gespeicherten ersten Teilsignals und zumindest eines digitalisierten und gespeicherten zweiten Teilsignals eines Multibandsignals und weist zusätzlich eine Speichereinheit, eine Verarbeitungseinheit und eine Anzeigevorrichtung auf. In einem ersten Verfahrensschritt wird ein Verlauf eines Fehler-Werts von dem ersten Teilsignal über einen bestimmten Zeitraum durch die Verarbeitungseinheit berechnet. In einem zweiten Verfahrensschritt wird der Verlauf des Fehler-Werts durch die Verarbeitungseinheit in einem ersten Fenster auf der Anzeigevorrichtung dargestellt. In einem dritten Verfahrensschritt setzt die Verarbeitungseinheit eine erste Analyselinie auf den Zeitpunkt, an dem der Verlauf des Fehler-Werts einen durch die Verarbeitungseinheit aus einer Speichereinheit geladenen Schwellwert überschreitet.

Bei dem erfindungsgemäßen Verfahren ist es besonders vorteilhaft, dass eine Analyselinie automatisch den Zeitpunkt des Verlaufs des Fehler-Werts eines ersten Teilsignals markiert, der für die Analyse des Multibandsignals, insbesondere der benachbarten Bänder des betroffenen Teilsignals relevant sein kann. Der Benutzer muss sich dadurch nicht mehr durch die Verläufe sämtlicher Teilsignale des Multibandsignals durcharbeiten, um eine relevante Stelle für eine weitere Analyse zu finden.

Ein weiterer Vorteil bei dem erfindungsgemäßen Messgerät besteht, wenn die Verarbeitungseinheit die erste Analyselinie im ersten Fenster auf den ersten Zeitpunkt setzt, an dem der Fehler-Wert den aus einer Speichereinheit geladenen Schwellwert überschreitet und/oder wenn die Verarbeitungseinheit die erste Analyselinie im ersten Fenster auf den Zeitpunkt setzt, an dem der Fehler-Wert am höchsten ist und gleichzeitig den aus einer Speichereinheit geladenen Schwellwert überschreitet und/oder wenn die Verarbeitungseinheit weitere Analyselinien im ersten Fenster auf weitere Zeitpunkte setzt, an denen die Fehler-Werte den aus einer Speichereinheit geladenen Schwellwert überschreiten. Je nach gewählter Einstellung wird dem Benutzer des Messgeräts gleich der erste Zeitpunkt mitgeteilt, an dem der Verlauf des Fehler-Werts einen Schwellwert überschreitet und/oder es wird dem Benutzer des Messgeräts der Zeitpunkt mitgeteilt, an dem der Fehler-Wert am höchsten ist und/oder es werden dem Benutzer sämtliche Zeitpunkte mitgeteilt, in denen die Fehler-Werte den eingestellten Schwellwert überschreiten, sodass diese Zeitpunkte im Folgendem mit einem anderen Programm automatisch analysiert werden können.

Außerdem besteht bei dem erfindungsgemäßen Messgerät ein Vorteil, wenn die Verarbeitungseinheit von dem ersten Teilsignal einen Verlauf der Leistung berechnet und in einem zweiten Fenster auf der Anzeigevorrichtung darstellt und wenn die Verarbeitungseinheit eine erste Analyselinie in dem zweiten Fenster auf den Zeitpunkt setzt, der dem Zeitpunkt entspricht, in dem die erste Analyselinie in dem ersten Fenster dargestellt ist und/oder wenn die Verarbeitungseinheit von dem zweiten Teilsignal einen Verlauf der Leistung berechnet und in einem dritten Fenster auf der Anzeigevorrichtung darstellt und wenn die Verarbeitungseinheit eine erste Analyselinie in dem dritten Fenster auf den Zeitpunkt setzt, der dem Zeitpunkt entspricht, in dem die erste Analyselinie in dem ersten Fenster dargestellt ist. Dadurch kann der Benutzer sofort erkennen, in welchem Slot (dt. Schlitz) ein Fehler vorliegt oder er kann die Ursache des erhöhten Fehler-Werts in einem anderen Teilsignal des Multibandsignals ausmachen, weil die zeitlich zueinander korrespondierenden Signalanteile angezeigt werden.

Im Weiteren besteht bei dem erfindungsgemäßen Messgerät ein Vorteil, wenn die Verarbeitungseinheit zumindest Teile des ersten Teilsignals und/oder des zweiten Teilsignals in weiteren Fenstern darstellt, wobei die Darstellung keine zeitabhängige Achse enthält, wobei ein Indikator, insbesondere in Form eines Symbols oder eines Buchstabenkürzels, innerhalb der weiteren Fenster signalisiert, dass in die Darstellung der Fehler-Wert einfließt auf dem die Verarbeitungseinheit in dem ersten Fenster eine erste Analyselinie gesetzt hat. Ein solcher Indikator ist insbesondere dann sinnvoll, wenn z.B. die Leistung der Code-Domäne dargestellt wird, sodass der Benutzer informiert ist, dass in dieser Darstellung ein Fehler vorhanden ist.

Auch besteht bei dem erfindungsgemäßen Messgerät ein Vorteil, wenn es sich bei dem ersten Teilsignal um ein WCDMA-Signal (engl. Wideband Code Division Multiple Access; dt. Breitbandiger Codemultiplex-Vielfachzugriff) handelt, oder wenn es sich bei dem Fehler-Wert um einen EVM-Wert (engl. Error Vector Magnitude; dt. Beitragszählervektor) handelt und wenn in dem ersten Fenster der Verlauf des EVM-Werts über verschiedene Chips (dt. Chips) aufgetragen ist, weil ein solcher Verlauf des EVM-Werts Hinweise auf eine fehlerhafte Demodulation liefert. Es ist dabei auch vorteilhaft, wenn in dem zweiten Fenster die Leistung über die Slots (engl. Power vs. Slot) aufgetragen ist und/oder wenn in dem zweiten Fenster die Leistung der Code-Domäne aufgetragen ist und/oder wenn es sich bei dem zweiten Teilsignal um ein TDMA-Signal (engl. Time Division Multiple Access; dt. Zeit Multiplex-Vielfachzugriff), insbesondere um ein GSM-Signal (engl. Global System for Mobile Communication; dt. Globales System zur mobilen Kommunikation) handelt. Es ist auch vorteilhaft, wenn in dem dritten Fenster die Leistung des zweiten Teilsignals in der Zeit-Domäne aufgetragen ist. Gerade die steilen Flanken insbesondere eines GSM-Burst können negative Auswirkungen auf die benachbarten Bänder haben. Ein solcher GSM-Burst kann folglich den Verlauf des EVM-Werts eines WCDMA-Signals negativ beeinflussen. Ein Benutzer erkennt anhand dieser zeitsynchronen Darstellung der verschiedenen Teilsignale, dass ein Fehler innerhalb des EVM-Verlaufs des WCDMA-Signals nicht in den Verstärkern oder der Signalverarbeitung für das WCDMA-Signal zu finden ist, sondern möglicherweise auf die Flanke des GSM-Bursts zurückzuführen ist. Die in diesem Teil beschriebenen Sachverhalte das Messgerät betreffend gelten selbstverständlich auch für die nachfolgenden Sachverhalte das Verfahren betreffend und umgekehrt.

Bei einer vorteilhaften Ausgestaltung des erfindungsgemäßen Verfahrens liegt außerdem ein Vorteil vor, wenn die Verarbeitungseinheit auf der Anzeigevorrichtung anstatt einer ersten Analyselinie oder zusätzlich zu einer ersten Analyselinie im ersten Fenster einen ersten Analysebereich zeichnet, der sich über eine Vielzahl von zeitlich zusammenhängenden Fehler-Werten erstreckt, wobei ein erster Fehlerwert ein erstes Ende des ersten Analysebereichs bildet, wobei dieser erste Fehler-Wert den aus einer Speichereinheit geladenen Schwellwert überschreitet und wobei ein weiterer Fehler-Wert ein zweites Ende des ersten Analysebereichs bildet, wobei dieser weitere Fehler-Wert ebenfalls den aus einer Speichereinheit geladenen Schwellwert überschreitet, wobei die zwischen dem ersten Ende und dem zweiten Ende des Analysebereichs liegenden Fehler-Werte alle den aus einer Speichereinheit geladenen Schwellwert überschreiten. Eine solche Darstellung ist deutlich übersichtlicher, als das Hinzufügen weiterer Analyselinien. Für eine weitere Verarbeitung können die entsprechenden Signalteile, die innerhalb des ersten Analysebereichs liegen, direkt einer anderen Anwendung übergeben werden.

Auch ist es bei dem erfindungsgemäßen Verfahren vorteilhaft, wenn die Verarbeitungseinheit den ersten Analysebereich anstatt einer ersten Analyselinie oder zusätzlich zu einer ersten Analyselinie dann zeichnet, wenn die Fehler-Werte die zwischen dem ersten Ende und dem zweiten Ende des zu zeichnenden Analysebereichs liegen, einen in der Speichereinheit gespeicherten Anzahl überschreiten. In diesem Fall kann sichergestellt werden, dass ein Analysebereich nur dann eingezeichnet wird, wenn eine bestimmte Anzahl von zeitlich aufeinanderfolgenden Fehler-Werten eine vorgegebene Anzahl überschreitet.

Verschiedene Ausführungsbeispiele der Erfindung werden nachfolgend unter Bezugnahme auf die Zeichnung beispielhaft beschrieben. Gleiche Gegenstände weisen dieselben Bezugszeichen auf. Die entsprechenden Figuren der Zeichnung zeigen im Einzelnen:
- Fig. 1: ein beispielhaftes Multibandsignal mit einem ersten Teilsignal, einem zweiten Teilsignal, einem dritten Teilsignal und einem vierten;
- Fig. 2: einen beispielhaften Aufbau des erfindungsgemäßen Messgeräts, um die verschiedenen Teilsignale aus dem Multibandsignal erfassen zu können;
- Fig. 3A: ein erstes Fenster auf der Anzeigevorrichtung, in dem ein Verlauf eines Fehler-Werts des ersten Teilsignals dargestellt ist;
- Fig. 3B: das erste Fenster auf der Anzeigevorrichtung, in dem der Verlauf des Fehler-Werts des ersten Teilsignals dargestellt ist und in dem eine erfindungsgemäße Analyselinie eingezeichnet ist;
- Fig. 3C: ein drittes Fenster auf der Anzeigevorrichtung, in dem eine Leistung in der Zeitdomäne des zweiten Teilsignals dargestellt ist und in dem die erfindungsgemäße Analyselinie an dem Zeitpunkt eingezeichnet ist, der dem Zeitpunkt entspricht, in dem die Analyselinie in dem ersten Fenster eingezeichnet ist;
- Fig. 3D: ein zweites Fenster auf der Anzeigevorrichtung, in dem eine Leistung über die Slots des ersten Teilsignals dargestellt ist und in dem die erfindungsgemäße Analyselinie an dem Zeitpunkt eingezeichnet ist, der dem Zeitpunkt entspricht, in dem die Analyselinie in dem ersten Fenster eingezeichnet ist;
- Fig. 3E: ein zweites Fenster auf der Anzeigevorrichtung, in dem eine Leistung der Code-Domäne des ersten Teilsignals zusammen mit einem Indikator dargestellt ist, der angibt, dass ein Fehler-Wert, der mit einer Analyselinie markiert ist, in die Berechnung zur Anzeige eingeflossen ist;
- Fig. 4A: das erste Fenster auf der Anzeigevorrichtung, in dem der Fehler-Wert des ersten Teilsignals dargestellt ist und in dem mehrere erfindungsgemäße Analyselinien und ein Analysebereich eingezeichnet sind;
- Fig. 4B: ein drittes Fenster auf der Anzeigevorrichtung, in dem eine Leistung in der Zeitdomäne des zweiten Teilsignals dargestellt ist und in dem mehrere erfindungsgemäße Analyselinien und ein Analysebereich an den Zeitpunkten eingezeichnet sind, die den Zeitpunkten entsprechen, in denen diese auch in dem ersten Fenster eingezeichnet sind;
- Fig. 4C: ein zweites Fenster auf der Anzeigevorrichtung, in dem eine Leistung über die Slots des ersten Teilsignals dargestellt ist und in dem die erfindungsgemäße Analyselinie und der erfindungsgemäße Analysebereich in dem Zeitpunkt eingezeichnet sind, der dem Zeitpunkt entspricht, in dem diese in dem ersten Fenster eingezeichnet sind;
- Fig. 5A: ein Flussdiagramm eines Ausführungsbeispiels des erfindungsgemäßen Verfahrens, das die Analyselinie beschreibt;
- Fig. 5B: ein weiteres Flussdiagramm eines Ausführungsbeispiels des erfindungsgemäßen Verfahrens, das die Analyselinie genauer beschreibt;
- Fig. 6: ein Flussdiagramm eines Ausführungsbeispiels des erfindungsgemäßen Verfahrens, das beschreibt, wie die Analyselinie auch in anderen Fenstern auf einen exakten Zeitpunkt gesetzt wird;
- Fig. 7A: ein Flussdiagramm eines Ausführungsbeispiels des erfindungsgemäßen Verfahrens, das einen Analysebereich beschreibt;
- Fig. 7B: ein Flussdiagramm eines Ausführungsbeispiels des erfindungsgemäßen Verfahrens, das beschreibt, wann der Analysebereich gezeichnet wird;
- Fig. 7C: ein Flussdiagramm eines Ausführungsbeispiels des erfindungsgemäßen Verfahrens, das beschreibt, wie der Analysebereich auch in anderen Fenstern auf einen exakten Zeitbereich gesetzt wird; und
- Fig. 8: ein Flussdiagramm eines Ausführungsbeispiels des erfindungsgemäßen Verfahrens, das einen Indikator beschreibt, der eine Analyselinie und/oder einen Analysebereich in Diagrammen ohne zeitabhängige Achse ersetzt.

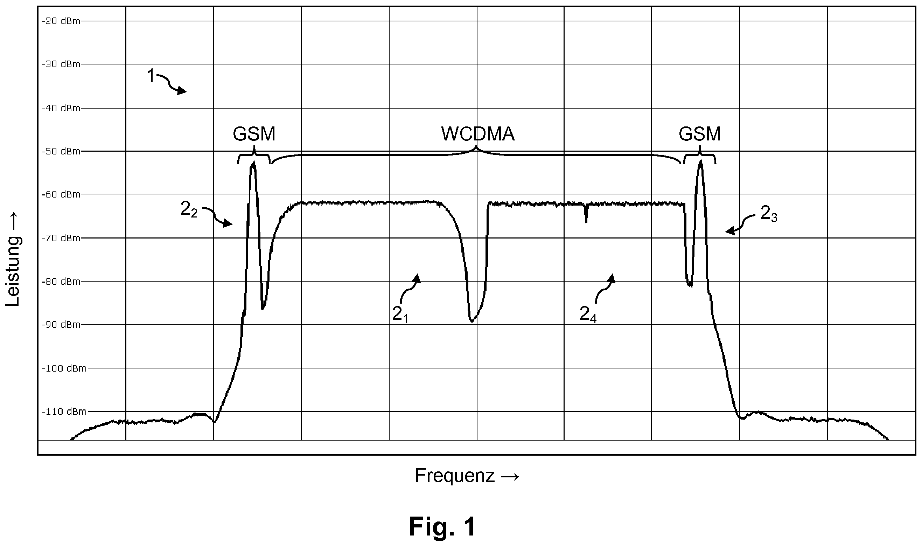

Fig. 1 zeigt ein beispielhaftes Multibandsignal 1 mit einem ersten Teilsignal 2₁, einem zweiten Teilsignal 2₂, einem dritten Teilsignal 2₃ und einem vierten Teilsignal 2₄. Bei dem beispielhaften Multibandsignal 1 handelt es sich um das Signal um einer nicht dargestellten Multibandbasisstation 12, wobei das Multibandsignal 1 mehrere Träger unterschiedlicher Mobilfunkstandards umfasst. In Fig. 1 ist dabei der spektrale Verlauf des Multibandsignals 1 dargestellt. In dem Ausführungsbeispiel aus Fig. 1 handelt es sich bei dem ersten Teilsignal 2₁ und bei dem vierten Teilsignal 2₄ um ein WCDMA-Signal. Bei dem zweiten Teilsignal 2₂ handelt es sich um ein GSM-Signal. Bei dem dritten Teilsignal 2₃ handelt es sich ebenfalls um ein GSM-Signal. Die WCDMA-Signale sind dabei so positioniert, dass sich an ihrem unteren Frequenzbereich und an ihrem oberen Frequenzbereich jeweils ein GSM-Signal anschließen. Steile Flanken innerhalb eines GSM-Bursts innerhalb des zweiten Teilsignals 2₂ und/oder innerhalb des dritten Teilsignals 2₃ können die Demodulation der WCDMA-Signale beeinflussen. Es ist natürlich auch möglich, dass es sich bei dem ersten Teilsignal 2₁, bei dem zweiten Teilsignal 2₂, bei dem dritten Teilsignal 2₃ und/oder bei dem vierten Teilsignal 2₄ um ein LTE-Signal (engl. long-term evolution; dt: Langzeitevolution) oder um ein WIMAX-Signal (engl. worldwide interoperability for microwave access; dt: drahtloser Zugriff mit weltweiter Kompatibilität) handelt.

Im Folgenden wird erläutert, wie das in Fig. 1 dargestellte Multibandsignal 1 erfasst wird und wie die einzelnen Teilsignale 2₁, 2₂, 2₃, 2₄ verarbeitet werden können. Im Übrigen kann das Multibandsignal 1 noch aus beliebig vielen weiteren Teilsignalen 2₁, 2₂, 2₃ und 2₄ bestehen. Einzig der besseren Übersichtlichkeit halber sind in Fig. 1 nur vier Teilsignale 2₁, 2₂, 2₃ und 2₄ dargestellt.

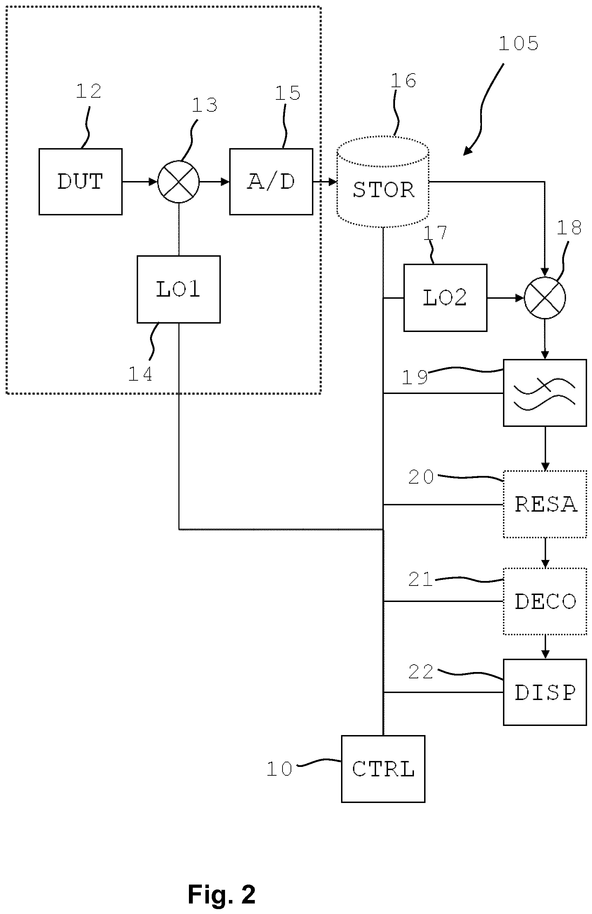

In Fig. 2 ist ein erstes Ausführungsbeispiel des erfindungsgemäßen Messgeräts dargestellt. Ein Messobjekt 12, insbesondere eine Multiband-Basisstation 12, ist mit einem Mischer 13 verbunden. Der Mischer 13 ist mit einem Lokaloszillator 14 und einem Analog-Digital-Wandler 15 verbunden. Dabei ist der Lokaloszillator 14 auch mit einer Verarbeitungseinheit 10 verbunden, die die notwendigen Steuerbefehle erzeugt. Der Mischer 13, der Lokaloszillator 14 und der Analog-Digital-Wandler 15 bilden gemeinsam eine Hochfrequenzverarbeitungseinrichtung. Das Messobjekt 12 ist nicht Teil davon.

Der Analog-Digital-Wandler 15 ist mit einer Speichereinheit 16 verbunden. Auch die Speichereinheit 16 ist mit der Verarbeitungseinheit 10 verbunden. Die Speichereinheit 16 ist darüber hinaus mit einem digitalen Mischer 18 verbunden, welcher mit einem digitalen Lokaloszillator 17 verbunden ist. Auch dieser ist mit der Verarbeitungseinheit 10 verbunden. Der Mischer 18 ist darüber hinaus mit einem Filter 19 verbunden. Auch das Filter 19 ist mit der Verarbeitungseinheit 10 verbunden. Das Filter 19 ist darüber hinaus mit einer Datenraten-Anpassungseinrichtung 20 verbunden. Diese ist ebenfalls mit der Verarbeitungseinheit 10 verbunden. Zusätzlich ist sie mit einer Dekodierungseinrichtung 21 verbunden, welche ebenfalls mit der Verarbeitungseinheit 10 verbunden ist. Darüber hinaus ist die Dekodierungseinrichtung 21 mit einer Anzeigeeinrichtung 22 verbunden, welche ebenfalls mit der Verarbeitungseinheit 10 verbunden ist.

Das Messobjekt 12 erzeugt ein Multibandsignal 1. Dieses wird an den Mischer 13 übertragen. Das Signal beinhaltet dabei mehrere Teilsignale 2₁, 2₂, 2₃, 2₄. Diese können von unterschiedlichen Telekommunikationsstandards sein. Der Mischer 13 mischt das Multibandsignal 1 mit einem Lokaloszillatorsignal, welches von dem Lokaloszillator 14 gesteuert von der Verarbeitungseinheit 10 erzeugt wird. Das resultierende Zwischenfrequenzsignal beinhaltet den gesamten Informationsgehalt des Multibandsignals 1, weist jedoch eine abweichende Mittenfrequenz auf. Das Zwischenfrequenzsignal wird anschließend von dem Analog-Digital-Wandler 15 zu einem digitalen Gesamtsignal digitalisiert. Dieses digitale Gesamtsignal wird anschließend von der Speichereinheit 16 gespeichert. Das digitale Gesamtsignal kann auf der Anzeigevorrichtung 22 entsprechend Fig. 1 als digitales Multibandsignal 1 angezeigt werden.

Gesteuert von der Verarbeitungseinheit 10 gibt die Speichereinheit 16 das gespeicherte digitale Gesamtsignal an den Mischer 18 aus, welcher es mit einem ersten Lokaloszillatorsignal mischt. Dieses Lokaloszillatorsignal wird dabei von dem Lokaloszillator 17 erzeugt, der von der Verarbeitungseinheit 10 gesteuert wird. Die Signalverarbeitung erfolgt ab dem Analog-Digital-Wandler 15 digital, d.h. es handelt sich um eine digitale Mischung mit einem digitalen Signal. Die Frequenz des Lokaloszillatorsignals wird dabei so gewählt, dass die Mittenfrequenz des aus der Mischung resultierenden ersten digitalen Gesamtmesssignals der Mittenfrequenz des zu untersuchenden Teilsignals 2₁, 2₂, 2₃, 2₄ entspricht. Die Frequenz des digitalen Gesamtsignals wird durch die Mischung von dem Mischer 18 somit derart verschoben, dass das resultierende erste digitale Gesamtmesssignal einfach weiterverarbeitet werden kann.

Dieses Signal wird nun dem digitalen Filter 19 zugeleitet. Das digitale Filter 19 beschränkt die Bandbreite des ersten digitalen Gesamtmesssignals auf die Bandbreite des gerade zu untersuchenden Teilsignals 2₁, 2₂, 2₃, 2₄. Bei dem Filter 19 handelt es sich bevorzugt um ein Tiefpassfilter. Alternativ kann auch ein Bandpassfilter eingesetzt werden. Als Ausgangssignal erzeugt das digitale Filter 19 ein erstes digitales Teilsignal 2₁. Dieses erste digitale Teilsignal 2₁ beinhaltet nun lediglich den Informationsgehalt des gerade untersuchten Teilsignals 2₁, 2₂, 2₃ oder 2₄. Es wird anschließend der Datenraten-Anpassungseinrichtung 20 zugeleitet, welche zur Untersuchung des jeweiligen Teilsignals 2₁, 2₂, 2₃ oder 2₄ unnötige Datenpunkte entfernt und so die Datenrate des ersten digitalen Teilsignals 2₁, 2₂, 2₃, 2₄ reduziert. Die Reduktion erfolgt dabei in Abhängigkeit von dem jeweiligen Kommunikationsstandard. Das Durchlaufen der Datenraten-Anpassungseinrichtung 20 ist dabei optional.

Das resultierende Teilsignal 2₁, 2₂, 2₃, 2₄ wird einer Dekodierungseinrichtung 21 zugeführt, welche das Signal dekodiert. Das dekodierte Teilsignal 2₁, 2₂, 2₃, 2₄ wird der Anzeigevorrichtung 22 zugeführt und von dieser dargestellt. Auch das Durchlaufen der Dekodierungseinrichtung 21 ist dabei optional. Alternativ können auch die nicht dekodierten Daten auf der Anzeigevorrichtung 22 angezeigt werden. Das digitale Filter 19, die Datenraten-Anpassungseinrichtung 20, die Dekodierungseinrichtung 21 und die Anzeigevorrichtung 22 werden dabei ebenfalls von der Verarbeitungseinheit 10 gesteuert. Auch die Datenraten-Anpassungseinrichtung 20 wird von der Verarbeitungseinheit 10 für das gerade zu untersuchende Teilsignal 2₁, 2₂, 2₃, 2₄ eingestellt. Dies gilt ebenso für die Dekodierungseinrichtung 21 und die Anzeigevorrichtung 22.

Nachdem wie oben beschrieben, ein erstes Teilsignal 2₁ des gespeicherten digitalen Multibandsignals 1 verarbeitet wurde, wird dieses Vorgehen für ein zweites Teilsignal 2₂ und evtl. weitere Teilsignale 2₃, 2₄ wiederholt. Die Verarbeitungseinheit 10 stellt nun das Lokaloszillatorsignal derart ein, dass die Mittenfrequenz des aus der Mischung resultierenden Signals der Mittenfrequenz des nun zu untersuchenden Teilsignals 2₂, 2₃, 2₄ entspricht. Das digitale Filter 19 wird ebenso eingestellt, um die Bandbreite des zu untersuchenden Teilsignals 2₂, 2₃, 2₄ passieren zu lassen und darüberhinausgehende Signalanteile zu entfernen. Analog zu dem oben beschriebenen Ablauf wird ein zweites digitales Teilsignal 2₂ erzeugt und wie bereits erläutert weiterverarbeitet. Selbiges geschieht für jedes der beliebig vielen weiteren Teilsignale 2₃, 2₄.

Das digitale Multibandsignal 1 kann alternativ direkt weiterverarbeitet werden, sofern lediglich ein Teilsignal 2₁, 2₂, 2₃ oder 2₄ untersucht werden soll. Soll jedoch ein zweites Teilsignal 2₂, 2₃, 2₄ untersucht werden, muss das digitale Gesamtmesssignal 105 wie beschrieben durch die Speichereinrichtung 16 abgespeichert und in Form des gespeicherten digitalen Multibandsignals 1 weiterverarbeitet werden.

Die Verarbeitung mehrerer Teilsignale durch die Funktionsblöcke 16 - 22 erfolgt dabei abschnittsweise nacheinander. D.h. zunächst wird ein zeitlicher Abschnitt eines ersten Teilsignals 2₁ verarbeitet. Anschließend wird ein identischer zeitlicher Abschnitt eines zweiten Teilsignals 2₂ verarbeitet. Nachdem sämtliche gerade darzustellende Teilsignale 2₁, 2₂, 2₃, 2₄ verarbeitet wurden, wird mit dem nächsten zeitlichen Abschnitt des ersten Teilsignals 2₁, 2₂, 2₃, 2₄ fortgefahren. Die Aufzeichnung durch die Speichereinrichtung 16 erfolgt dabei kontinuierlich.

Alternativ ist auch eine parallele Verarbeitung mehrerer Teilsignale möglich. Hierzu verfügt das Messgerät über eine zumindest zweifache Ausführung der Funktionsblöcke 17 - 21. Die Steuereinrichtung 10 steuert diese Funktionsblöcke 17 - 21 in diesem Fall parallel an. Die Funktionsblöcke 17 - 21 sind bevorzugt in einem FPGA (engl. Field Programmable Gate Array; dt. im (Anwendungs-) Feld programmierbare (Logik-) Gatter-Anordnung)) ausgebildet. Auch eine abschnittsweise Aufzeichnung des gespeicherten digitalen Gesamtsignals 105 ist möglich.

Im nachfolgenden Teil werden jeweils die gleichen, also die zeitlich zueinander korrespondierenden Abschnitte der unterschiedlichen Teilsignale 2₁, 2₂, 2₃, 2₄ betrachtet. Liegt ein ungewöhnlicher EVM-Wert in einem zeitlichen Abschnitt, der insbesondere einem Frame (dt. Rahmen) entspricht, in einem Teilsignal vor, dann werden die dazu korrespondierenden zeitlichen Abschnitte der anderen Teilsignale 2₁, 2₂, 2₃, 2₄ zum Vergleich mit heran gezogen und entsprechend dargestellt.

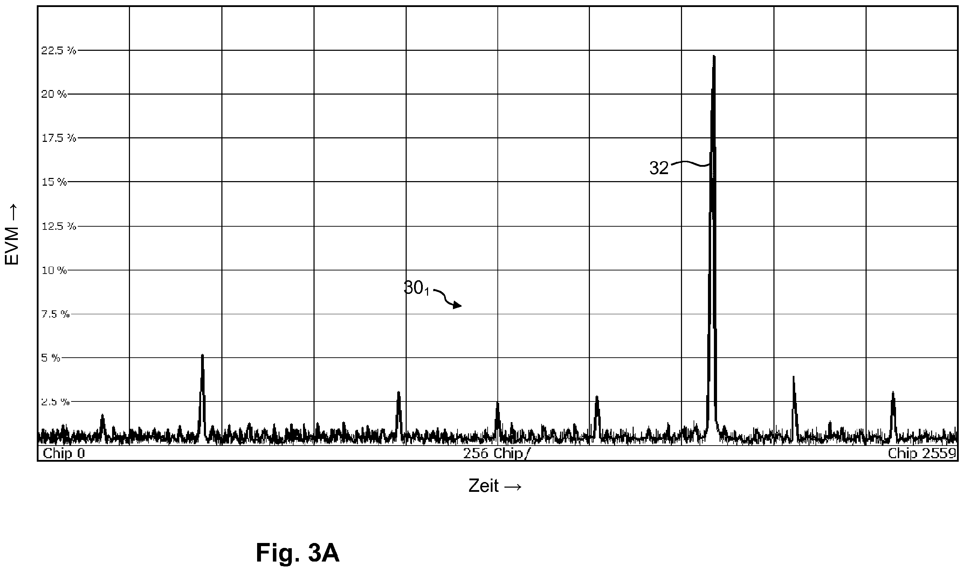

Fig. 3A zeigt ein erstes Fenster auf der Anzeigevorrichtung 22, in dem ein Verlauf eines Fehler-Werts 30₁ des ersten Teilsignals 2₁ dargestellt ist. Bei dem ersten Teilsignal 2₁ handelt es sich bevorzugt um ein WCDMA-Signal. Bei dem Fehlerwert handelt es sich bevorzugt um den EVM-Wert 30₁ des ersten Teilsignals 2₁. Das erste Fenster, in dem der EVM-Wert 30₁ des ersten Teilsignals 2₁ dargestellt ist, weist eine zeitliche Koordinatenachse auf. Der EVM-Wert 30₁ ist dabei über die Zeit aufgetragen. Die Zeitachse kann in Mikrosekunden oder in Chips skaliert sein, wobei eine Auftragung des EVM-Werts 30₁ über die verschiedenen Chips vorteilhafter ist. Gut zu erkennen ist in Fig. 3A, dass der Verlauf des EVM-Werts 30₁ eine Spitze 32 aufweist. Diese Spitze 32 deutet auf ein Problem bei der Demodulierung des WCDMA-Signals hin. Ein Benutzer kann anhand dieser Spitze 32 bisher nur feststellen, dass es ein solches Problem gibt, nicht allerdings die möglichen Ursachen schnell und präzise bestimmen.

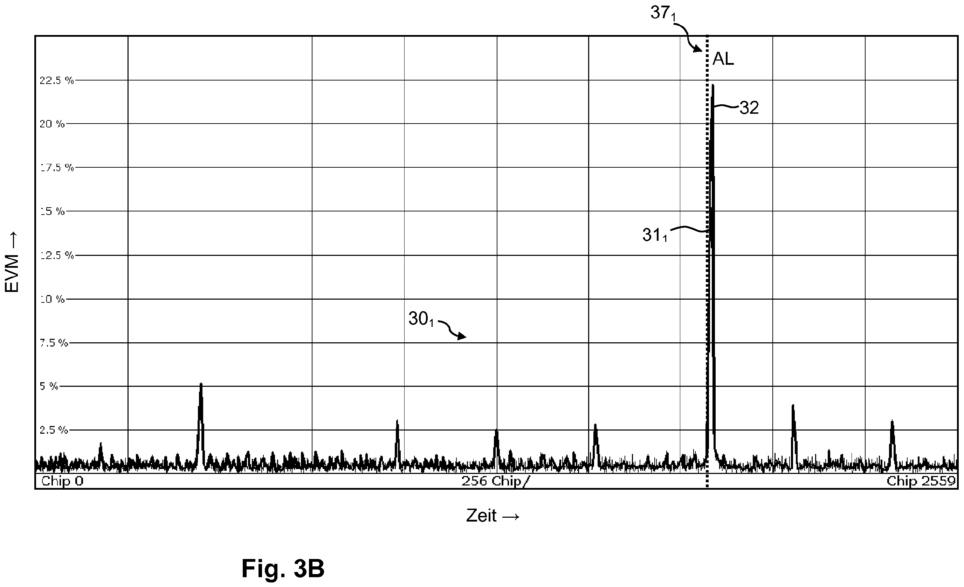

Fig. 3B zeigt wiederum das erste Fenster aus Fig. 3A, in dem der Verlauf des EVM-Werts 30₁ des ersten Teilsignals 2₁ dargestellt ist. Gleichzeitig hat die Verarbeitungseinheit 10 einen erste Analyselinie 31₁ an die Stelle des Verlaufs des EVM-Werts 30₁ gesetzt, welche einen bestimmten in einer Speichereinheit 16 gespeicherten Schwellwert überschreitet. Die Verarbeitungseinheit 10 berechnet folglich für jeden Konstellationspunkt des ersten Teilsignals 2₁ den entsprechenden EVM-Wert 30₁.

Entsprechend der Auflösung der Anzeigevorrichtung 22 werden die einzelnen EVM-Werte zur Darstellung dezimiert. Die Dezimation kann innerhalb der Verarbeitungseinheit 10 mittels eines Peak-Detektors, eines Average-Detektors oder eines Max-Detektors erfolgen. Bevorzugt wird in dem ersten Fenster auf der Anzeigevorrichtung 22 der Verlauf des EVM-Werts 30₁ über einen Frame (dt. Rahmen) dargestellt.

Die erste Analyselinie 31₁ wird durch die Verarbeitungseinheit 10 im ersten Fenster auf den ersten Zeitpunkt gesetzt, an den der Verlauf des EVM-Werts 30₁ den aus einer Speichereinheit 16 geladenen Schwellwert überschreitet. Es ist auch möglich, dass die Verarbeitungseinheit 10 die erste Analyselinie 31₁ im ersten Fenster auf den Zeitpunkt setzt, an dem der Verlauf des EVM-Werts 30₁ am höchsten ist, wobei dieser EVM-Wert 30₁ gleichzeitig auch den aus einer Speichereinheit 16 geladenen Schwellwert überschreiten muss. Dieser Schwellwert kann von einem Benutzer eingegeben werden, oder er kann dem zugrundeliegenden Kommunikationsstandard entnommen werden.

Die erste Analyselinie 31₁ wird bevorzugt in einer Farbe dargestellt, die keinem Teilsignal 2₁, 2₂, 2₃, 2₄ zugeordnet ist und die sich ebenfalls von dem Hintergrund und der Rasterung des ersten Fensters der Anzeigevorrichtung 22 abhebt. Die erste Analyselinie 31₁ kann auch in einem anderen Muster dargestellt werden. Beispielsweise muss die erste Analyselinie 31₁ keine vollständig durchgezogene Linie sein, sie kann auch gepunktet und/oder gestrichelt dargestellt sein. Die erste Analyselinie 31₁ kann auch transparent dargestellt werden, wobei ihr Kontrast niedriger ist als der Kontrast des Verlaufs des EVM-Werts 30 bezogen auf die Hintergrundfarbe und die mögliche Rasterung des ersten Fensters der Anzeigevorrichtung 22. Bei der ersten Analyselinie 31₁ handelt es sich um eine vertikale Linie, die bevorzugt über die gesamte Höhe des ersten Fensters der Anzeigevorrichtung 22 ausgebildet ist. Die erste Analyselinie 31₁ wird bevorzugt mit einem Indikator 37₁, insbesondere einem Symbol oder einem Buchstabenkürzel, wie z. B. "AL", markiert. Sobald mehrere Analyselinien ausgebildet sind, kann dieser Indikator noch mit einer Nummer versehen werden, die fortlaufend je nach Anzahl der Analyselinien iteriert wird.

Die erste Analyselinie 31₁ wird bevorzugt auf den Zeitpunkt im ersten Fenster gesetzt, an dem der Verlauf des EVM-Werts 30₁ mit positiver Steigung den in der Speichereinheit 16 gespeicherten Schwellwert überschreitet. Es ist ebenfalls möglich, dass zusätzlich zu dem Schwellwert noch ein Hysteresewert in der Speichereinheit 16 gespeichert wird. Dieser Hysteresewert bewirkt, dass die Verarbeitungseinheit 10 die erste Analyselinie 31₁ nur dann in das erste Fenster einzeichnet, wenn der Verlauf des EVM-Werts 30₁ den Hysteresebereich vollständig durchlaufen hat.

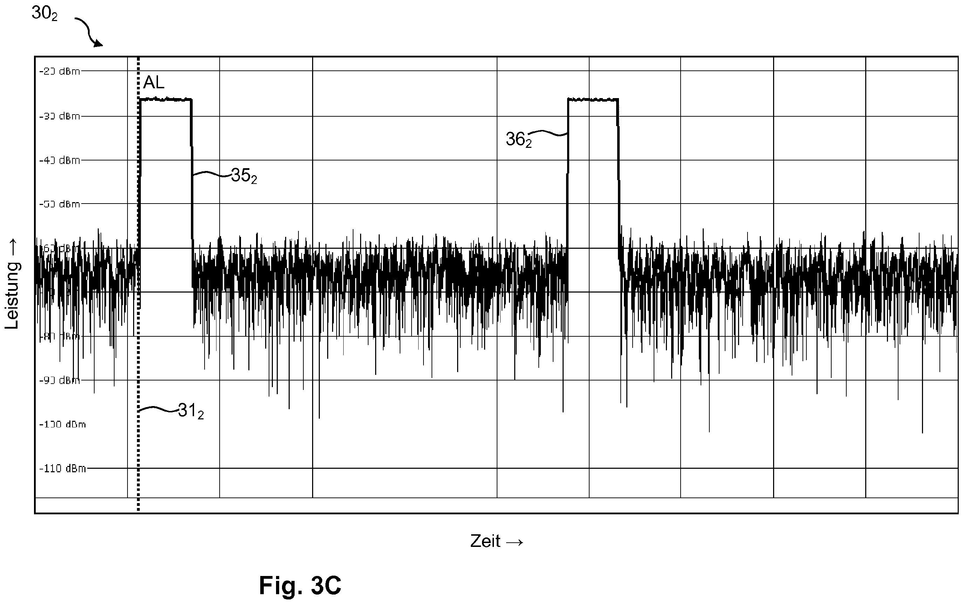

Fig. 3C zeigt ein drittes Fenster auf der Anzeigevorrichtung 22, in dem eine Leistung 30₂ des zweiten Teilsignals 2₂ in der Zeitdomäne dargestellt ist. Bei dem zweiten Teilsignal 2₂ handelt es sich bevorzugt um ein GSM-Signal. Die zeitliche Achse des zweiten Fensters umfasst die gleiche Zeitdauer wie die zeitliche Achse in dem ersten Fenster. Die Zeitdauer in Fig. 3C wird allerdings bevorzugt in Mikrosekunden oder Millisekunden angegeben. Gut zu erkennen sind in Fig. 3C zwei GSM-Bursts 35₂, 36₂. Die Verarbeitungseinheit 10 hat dabei von dem zweiten Teilsignal 2₂ einen zeitlichen Verlauf der Leistung 30₂, also den Verlauf 30₂ Leistung in der Zeitdomäne, berechnet und in dem dritten Fenster auf der Anzeigevorrichtung 22 dargestellt. Die Verarbeitungseinheit 10 hat außerdem in dem dritten Fenster eine erste Analyselinie 31₂ auf den Zeitpunkt gesetzt, der dem Zeitpunkt entspricht, in dem die erste Analyseline 31₁ in dem ersten Fenster dargestellt ist. Dies ist kein Problem, weil, wie in Fig. 2 erörtert wurde, stets zeitlich gleich lange Abschnitte der Teilsignale 2₁, 2₂, 2₃, 2₄ erzeugt werden, wobei die Zeitdauer eines Abschnitts bevorzugt 1 Frame und damit 10ms beträgt. Der zeitliche Zusammenhang zwischen den einzelnen Teilsignalen 2₁, 2₂, 2₃, 2₄ geht durch die abschnittsweise Berechnung, die nacheinander oder parallel erfolgt, nicht verloren.

Die erste Analyselinie 31₂ im dritten Fenster der Anzeigevorrichtung 22 weist dabei die gleiche Farbe und die gleiche Form auf, wie die erste Analyseline 31₁ im ersten Fenster der Anzeigevorrichtung 22. Um die Übersicht zu erhöhen, haben die Analyselinien 31₁, 31₂, die in den verschiedenen Fenstern den gleichen Zeitpunkt markieren, dasselbe Bezugszeichen, wobei der Index dem jeweiligen Fenster angepasst ist. Für einen Benutzer ist bei Betrachtung von Fig. 3C klar, dass möglicherweise die steile Flanke des GSM-Bursts 35₂ verantwortlich für den zu hohen EVM-Wert 30₁ des WCDMA-Signals gewesen sein könnte und diese Flanke genauer untersucht werden muss.

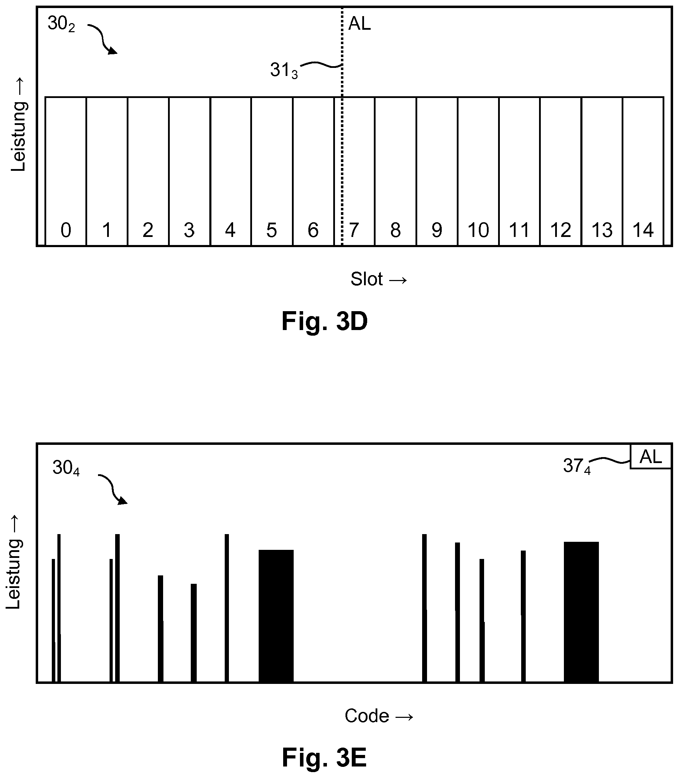

Fig. 3D zeigt ein zweites Fenster auf der Anzeigevorrichtung 22, in dem eine Leistung 30₃ des ersten Teilsignals 2₁ über die verschiedenen Slots (dt. Schlitze) dargestellt ist. Wie bereits erläutert, werden die einzelnen Teilsignale 2₁, 2₂, 2₃, 2₄ abschnittsweise durch das Messgerät 12 verarbeitet, damit der zeitliche Zusammenhang nicht verloren geht. Ein Abschnitt entspricht dabei bevorzugt einem Frame, wobei ein Frame sich aus 15 Slots zusammensetzt und 15 ms lang ist. Gut zu erkennen ist, dass die Verarbeitungseinheit 10 von dem ersten Teilsignal 2₁ den Verlauf der Leistung 30₃ über die Slots berechnet und diesen Verlauf in einem zweiten Fenster auf der Anzeigevorrichtung 22 darstellt. Die Leistung 30₃ wird dabei ebenfalls über eine Zeitachse aufgetragen. Die Verarbeitungseinheit 10 setzt dabei die erste Analyselinie 31₃ in dem zweiten Fenster auf den Zeitpunkt, der dem Zeitpunkt entspricht, in dem die erste Analyselinie 31₁ in dem ersten Fenster dargestellt ist. In dem Ausführungsbeispiel aus Fig. 3D kann ein Benutzer sehen, dass die Spitze 32 des EVM-Werts 30₁ in Slot 7 aufgetreten ist.

Fig. 3E zeigt ein zweites Fenster auf der Anzeigevorrichtung 22, in dem eine Leistung 30₄ der Code-Domäne des ersten Teilsignals 2₁ dargestellt ist. Dabei wird die Leistung 30₄ nicht auf einer Zeitachse dargestellt. Es wird vielmehr die Leistung 30₄ der einzelnen verwendeten Codes miteinander verglichen. Aufgrund der Tatsache, dass in dem Fenster aus Fig. 3E keine zeitabhängige Achse vorhanden ist, ist es nicht möglich, dass eine der Analyselinie 31₁ entsprechende Analyselinie eingezeichnet werden kann. Deshalb dient ein Indikator 37₄, insbesondere in Form eines Symbols oder eines Buchstabenkürzels dazu, um dem Benutzer zu signalisieren, dass in die Darstellung dennoch der Fehler-Wert 30₁, insbesondere der EVM-Fehler 30₁, eingeflossen ist, auf den die Verarbeitungseinheit 10 in dem ersten Fenster eine erste Analyselinie 31₁ gesetzt hat. Bevorzugt wird ein solcher Indikator 37₄ am Rand oder in der Ecke des entsprechenden Fensters platziert. Bei dem Indikator 37₄ handelt es sich insbesondere um dieselbe Abkürzung, mit der auch die Analyselinie 31₁ bezeichnet wird. Beispielsweise kann die Abkürzung "AL" oder "AL 1" eingeblendet werden, die signalisieren soll, dass der Fehler-Wert 30₁ auf den die entsprechende Analyselinie 31₁ im ersten Fenster gesetzt ist, in die Berechnung Einzug erhalten hat. Dabei weist der Indikator 37₄ die gleiche Farbe und/oder das gleiche Muster auf, wie die zu ihm korrespondierende erste Analyselinie 31₁.

Auf der Anzeigevorrichtung 22, bei der es sich bevorzugt um einen berührungsempfindlichen Bildschirm handelt, können das erste Fenster, das zweite Fenster, das dritte Fenster und ggf. noch weitere Fenster parallel zur gleichen Zeit dargestellt werden. Die einzelnen Fenster sind dabei nebeneinander und/oder übereinander angeordnet. Insbesondere kann der EVM-Wert 30₁ des Teilsignals 2₁ über die verschiedenen Chips zusammen mit der Leistung des ersten Teilsignals 2₁ über die einzelnen Slots und über die Code-Domäne in drei verschiedenen Fenstern parallel angezeigt werden. Parallel dazu kann ebenfalls die Leistung des zweiten Teilsignals 2₂ in der Zeitdomäne angezeigt werden. Die Fenster können auch sequentiell zueinander angezeigt werden.

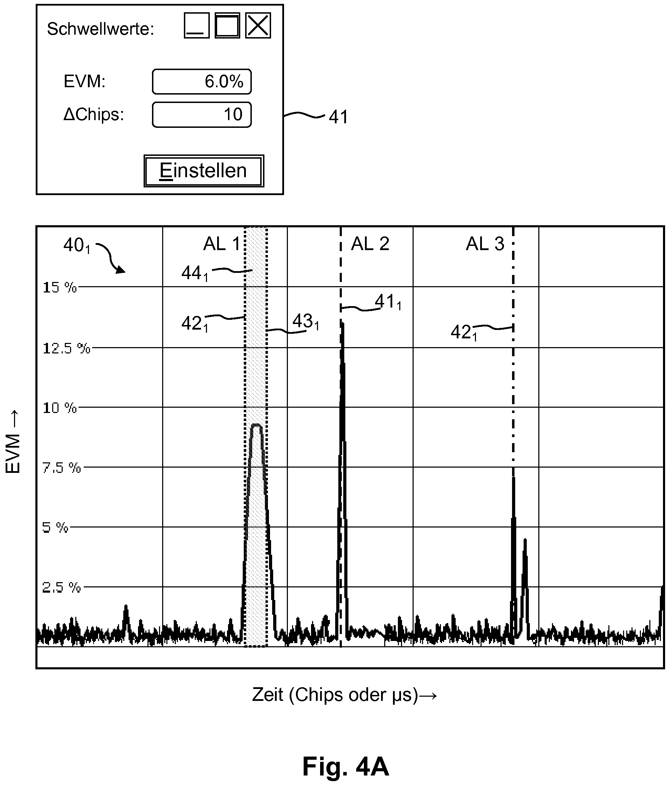

Fig. 4A zeigt das erste Fenster, in dem der Verlauf für den EVM-Wert 40₁ des ersten Teilsignals 2₁ dargestellt ist und in dem mehrere erfindungsgemäße Analyselinien 41₁, 42₁ dargestellt sind und in das zusätzlich ein Analysebereich 44₁ eingezeichnet ist.

Gut zu erkennen ist, dass der Verlauf des EVM-Werts 40₁ mehrere Maxima aufweist. Eine erste Analyselinie 41₁ wird von der Verarbeitungseinheit 10 auf den Zeitpunkt gesetzt, an dem der Verlauf des EVM-Werts 40₁ den höchsten Wert aufweist. Eine zweite Analyselinie 42₁ wird auf einen Zeitpunkt gesetzt, an dem der Verlauf des EVM-Werts 40₁ abermals einen in der Speichereinheit 16 gespeicherten Schwellwert überschreitet. Die erste Analyselinie 41₁ und die zweite Analyselinie 42₁ weisen bevorzugt unterschiedliche Farben und/oder unterschiedliche Muster auf. Die Farben beider Analyselinien 41₁, 42₁ unterscheiden sich allerdings von den in dem ersten Fenster verwendeten Farben, die insbesondere dem Verlauf des EVM-Werts 30₁, sowie dem Hintergrund und der Rasterung des Fensters zugwiesen sind.

Gut zu erkennen ist, dass in einem Eingabefeld 41 der Schwellwert für denjenigen EVM-Wert 30 eingegeben werden kann, ab dessen Erreichen die Verarbeitungseinheit 10 eine Analyselinie 41₁, 42₁ oder einen Analysebereich 44₁ auf den entsprechenden Zeitpunkt setzt.

Die Verarbeitungseinheit 10 kann im Übrigen anstatt einer ersten Analyselinie 41₁ oder anstatt von weiteren Analyselinien 42₁ einen ersten Analysebereich 44₁ in das erste Fenster einzeichnen. Die Verarbeitungseinheit 10 kann auch zusätzlich zu vorhandenen Analyselinien 41₁, 42₁ einen ersten Analysebereich 44₁ in das erste Fenster einzeichnen. Der erste Analysebereich 44₁ erstreckt sich über eine Vielzahl von zeitlich zusammenhängenden EVM-Werten 40₁. Ein erster EVM-Wert, der einen aus der Speichereinheit 16 geladenen Schwellwert überschreitet, bildet dabei ein erstes Ende 42₁ des Analysebereichs 44₁. Ein weiterer EVM-Wert, der einen aus einer Speichereinheit geladenen Schwellwert überschreitet, bildet ein zweites Ende 43₁ des Analysebereichs 44₁. Zwischen dem ersten Ende 42₁ und dem zweiten Ende 43₁ des Analysebereichs 44₁ liegen ausschließlich EVM-Werte, die alle den aus einer Speichereinheit 16 geladenen Schwellwert überschreiten. EVM-Werte 40₁, die zeitlich vor den EVM-Wert auftreten, der das erste Ende 42₁ bildet, überschreiten den aus einer Speichereinheit 16 geladen Schwellwert nicht. Gleiches gilt ebenfalls für EVM-Werte 40₁, die zeitlich direkt an den EVM-Wert anschließen, der das zweite Ende 43₁ des Analysebereichs 44₁ bildet. Der Analysebereich 44₁ markiert folglich eine Fläche. Die von dem Analysebereich 44₁ markierte Fläche wird bevorzugt in einer anderen Farbe und/oder in einem anderen Muster dargestellt als der Verlauf des EVM-Werts 40₁. Die Farbe ist ebenfalls nicht identisch zu der Hintergrundfarbe des ersten Fensters oder der Rasterung des ersten Fensters.

Die Analyselinien 41₁, 42₁ weisen ebenfalls eine unterschiedliche Farbe bezüglich der von dem Analysebereich 44₁ markierten Fläche auf. Die von dem Analysebereich 44₁ markierte Fläche kann auch bezüglich ihres Kontrasts gegenüber dem Verlauf des EVM-Werts 40₁ transparent dargestellt sein. In Fig. 4A wird beispielsweise der Verlauf des EVM-Werts 40₁ auch innerhalb der von Analysebereich 44₁ markierten Fläche dargestellt.

Bevorzugt zeichnet die Verarbeitungseinheit 10 einen solchen Analysebereich 44₁ nur, wenn die EVM-Werte, die zwischen dem ersten Ende 42₁ und dem zweiten Ende 43₁ des zu zeichnenden Analysebereichs 44₁ liegen, eine in der Speichereinheit 16 gespeicherte Anzahl überschreiten. Diese gespeicherte Anzahl kann beispielsweise über das Eingabefeld 41 eingegeben werden. In dem Ausführungsbeispiel aus Fig. 4A müssen zwischen dem ersten Ende 42₁ und dem zweiten Ende 43₁, die den Analysebereich 44₁ bilden, mindestens 10 Chips liegen, wobei der EVM-Wert 40₁ für jeden Chip den in der Speichereinheit 16 gespeicherten Schwellwert überschreiten muss. Anstatt der Anzahl der Chips kann auch eine Zeitdauer z.B. in Mikrosekunden oder Millisekunden angegeben werden.

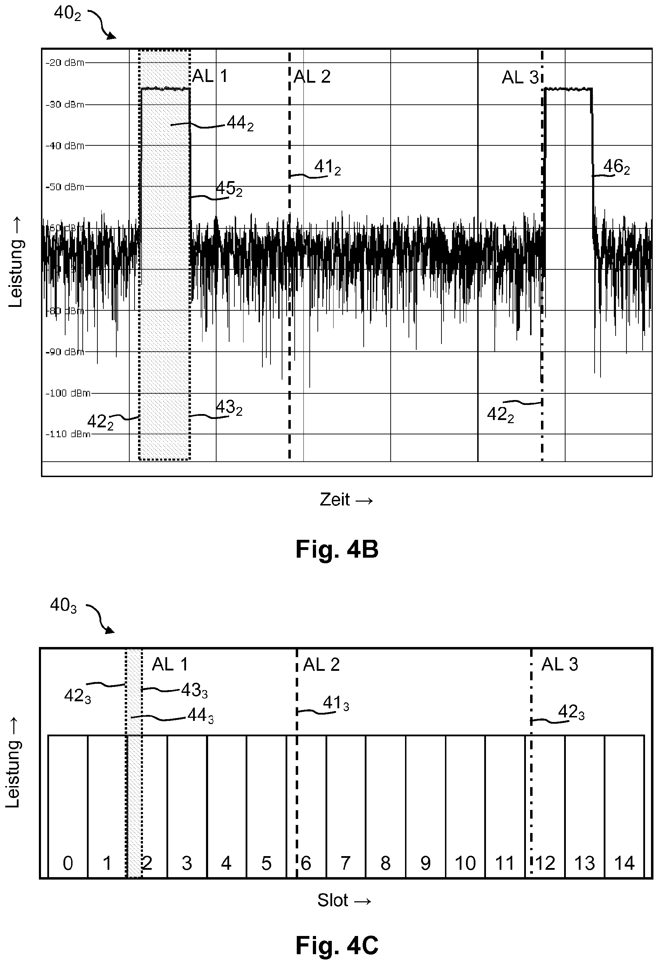

Fig. 4B zeigt ein drittes Fenster auf der Anzeigevorrichtung 22, in dem eine Leistung 40₂ des zweiten Teilsignals 2₂ in der Zeitdomäne dargestellt ist. Dabei berechnet die Verarbeitungseinheit 10 von dem zweiten Teilsignal 2₂ den Verlauf der Leistung 40₂ und stellt diesen in dem dritten Fenster dar. Weiterhin setzt die Verarbeitungseinheit 10 einen ersten Analysebereich 44₂ in dem dritten Fenster auf den Zeitbereich, der dem Zeitbereich entspricht, in dem der erste Analysebereich 44₁ in dem ersten Fenster dargestellt ist. Gut zu erkennen ist, dass möglicherweise der gesamte erste GSM-Burst 45₁ für den erhöhten EVM-Wert verantwortlich sein kann.

Die Verarbeitungseinheit 10 setzt in das dritte Fenster ebenfalls die erste Analyselinie 41₂ auf den Zeitpunkt, der dem Zeitpunkt entspricht, auf dem die erste Analyselinie 41₁ im ersten Fenster gesetzt ist. Gut zu erkennen ist, dass der Verlauf des GSM-Signals, also des zweiten Teilsignals 2₂, höchstwahrscheinlich nicht für den erhöhten EVM-Wert verantwortlich ist, auf den die erste Analyselinie 41₁ gesetzt ist.

Anders sieht es allerdings bei der zweiten Analyselinie 42₂ aus, die durch die Verarbeitungseinheit direkt auf die steigende Flanke des zweiten GSM-Burts 35₂ gesetzt wird.

Fig. 4C zeigt ein zweites Fenster auf der Anzeigevorrichtung 22, in dem eine Leistung 40₃ über die Slots des ersten Teilsignals 2₂ dargestellt ist. Der Verlauf der Leistung 40₃ über die Slots wird ebenfalls von der Verarbeitungseinheit 10 berechnet. Die Verarbeitungseinheit 10 setzt den ersten Analysebereich 44₃ in dem zweiten Fenster auf den Zeitbereich, der dem Zeitbereich entspricht, in dem der erste Analysebereich 44₁ in dem ersten Fenster dargestellt ist. Der erste Analysebereich 44₃ fällt in dem Ausführungsbeispiel aus Fig. 4C auf Slot zwei. Dargestellt sind ebenfalls die beiden Analyselinien 41₃ in Slot sechs und 42₃ in Slot zwölf.

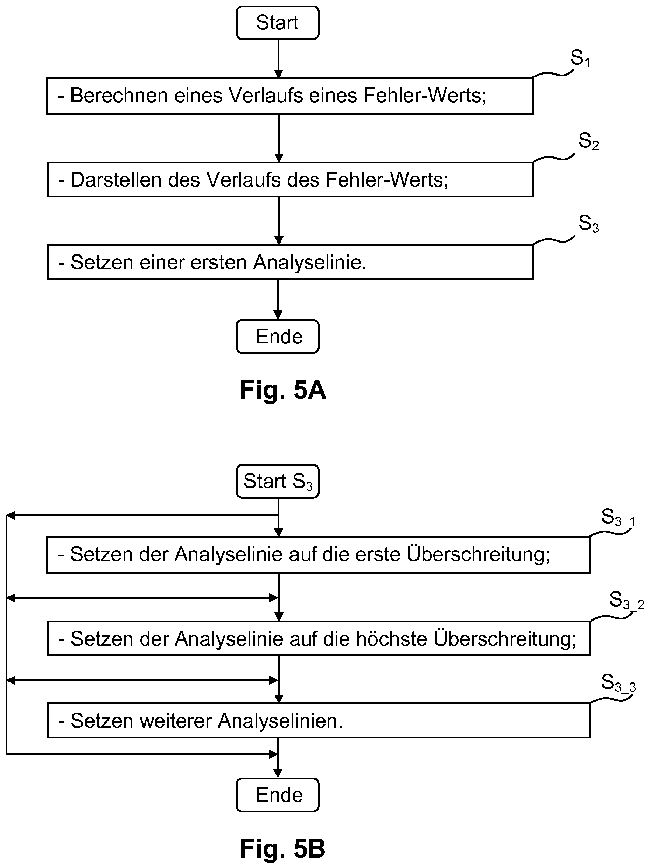

Fig. 5A beschreibt ein Flussdiagramm eines Ausführungsbeispiels des erfindungsgemäßen Verfahrens. In einem ersten Verfahrensschritt S₁ wird der Verlauf eines Fehler-Werts 30₁, insbesondere des EVM-Werts 30₁, von dem ersten Teilsignal 2₁ über einen bestimmten Zeitraum durch die Verarbeitungseinheit 10 berechnet. Bei dem bestimmten Zeitraum handelt es sich um einen Zeitraum, der durch einen Benutzer eingestellt werden kann und insbesondere einer Zeitdauer von einem Frame entspricht.

Im Anschluss daran wird der Verfahrensschritt S₂ ausgeführt. Innerhalb des Verfahrensschritts S₂ wird der Verlauf des Fehler-Werts 30₁, also des EVM-Werts 30₁, in einem ersten Fenster auf der Anzeigevorrichtung 22 durch die Verarbeitungseinheit 10 dargestellt. Bei dem ersten Teilsignal 2₁ kann es sich um ein WCDMA-Signal handeln.

Im Anschluss daran wird der Verfahrensschritt S₃ ausgeführt. Innerhalb des Verfahrensschritts S₃ setzt die Verarbeitungseinheit 10 eine erste Analyselinie 31₁ auf den Zeitpunkt, an den der Verlauf des Fehler-Werts 30₁ einen durch die Verarbeitungseinheit 10 aus einer Speichereinheit 16 geladenen Schwellwert überschreitet. Hierbei ist es besonders vorteilhaft, dass ein kritischer Fehler-Wert dem Benutzer automatisch dadurch angezeigt wird, dass die Verarbeitungseinheit 10 eine erste Analyselinie 31₁ auf den entsprechenden Zeitpunkt setzt. Der Benutzer kann aufgrund der Höhe des Fehler-Werts, bei dem es sich um den EVM-Wert handelt, direkt Aussagen, über das Modulationsergebnis treffen.

Fig. 5B beschreibt ein weiteres Flussdiagramm eines Ausführungsbeispiels des erfindungsgemäßen Verfahrens, das die Analyselinie 31₁ genauer beschreibt. Der beschriebene Verfahrensschritt S₃ kann einen oder mehrere der nachfolgenden Verfahrensschritte S_{3_1}, S_{3_2} oder S_{3_3} beinhalten. Innerhalb des Verfahrensschritts S_{3_1} setzt die Verarbeitungseinheit 10 eine erste Analyselinie 31₁ im ersten Fenster direkt auf den ersten Zeitpunkt, an dem der Fehler-Wert den aus einer Speichereinheit 16 geladenen Schwellwert überschreitet. Dadurch wird direkt der erste EVM-Wert für einen Benutzer markiert, der innerhalb eines Frames einen vorgegebenen Schwellwert überschreitet.

Alternativ dazu kann auch der Verfahrensschritt S_{3_2} ausgeführt werden. Innerhalb des Verfahrensschritts S_{3_2} setzt die Verarbeitungseinheit 10 die erste Analyselinie 31₁ im ersten Fenster auf den Zeitpunkt, an dem der Fehlerwert 30₁ am höchsten ist, wobei der Fehler-Wert 30₁ gleichzeitig den aus einer Speichereinheit 16 geladenen Schwellwert überschreitet. Dies bedeutet, dass für jeden zu analysierenden Zeitabschnitt, wie er in Fig. 2 definiert wurde, der insbesondere einem Frame entspricht, keine oder genau eine erste Analyselinie 31₁ im ersten Fenster gesetzt wird.

Zusätzlich oder alternativ dazu kann der Verfahrensschritt S_{3_3} ausgeführt werden. Innerhalb des Verfahrensschritts S_{3_3} setzt die Verarbeitungseinheit 10 weitere Analyselinien im ersten Fenster auf weitere Zeitpunkte, an denen die Fehler-Werte 30₁ den aus einer Speichereinheit 16 geladenen Schwellwert überschreiten. Dabei ist die Anzahl der weiteren Analyselinien nicht beschränkt. Die Analyselinien unterscheiden sich in ihrer Farbe und/oder ihrer Musterung von dem Verlauf des Fehler-Werts 30₁.

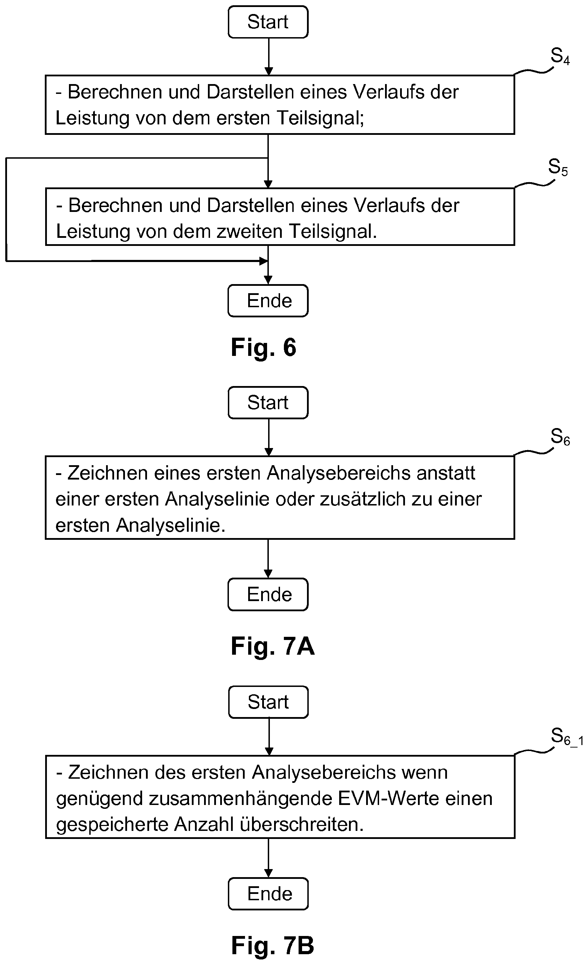

Fig. 6 zeigt ein Flussdiagramm eines Ausführungsbeispiels des erfindungsgemäßen Verfahrens, das beschreibt, wie die Analyselinie 31₁ auch in anderen Fenstern auf einen exakten Zeitpunkt gesetzt wird. Hierzu wird der Verfahrensschritt S₄ bevorzugt im Anschluss an den Verfahrensschritt S₃ ausgeführt. Innerhalb des Verfahrensschritts S₄ berechnet die Verarbeitungseinheit 10 den Verlauf der Leistung 30₃ von dem ersten Teilsignal 2₁ und stellt diesen in einem zweiten Fenster auf der Anzeigevorrichtung 22 dar. Bevorzugt wird in diesem Fenster die Leistung 30₃ über die einzelnen Slots aufgetragen. Weiterhin setzt die Verarbeitungseinheit 10 eine erste Analyselinie 31₃ in dem zweiten Fenster auf den Zeitpunkt, der dem Zeitpunkt entspricht, in dem die erste Analyselinie 31₁ in dem ersten Fenster dargestellt ist. Dies gelingt besonders einfach dadurch, dass auch das zweite Fenster die gleiche zeitliche Skalierung, nämlich einen Frame, hat wie das erste Fenster.

Im Anschluss oder alternativ zu dem Verfahrensschritt S₄ kann auch der Verfahrensschritt S₅ ausgeführt werden. Innerhalb des Verfahrensschritts S₅ wird der Verlauf der Leistung 30₂ von dem zweiten Teilsignal 2₂ durch die Verarbeitungseinheit 10 berechnet und in einem dritten Fenster auf der Anzeigevorrichtung 22 dargestellt. Der Verlauf der Leistung 30₂ wird ebenfalls bevorzugt in der Zeitdomäne dargestellt. Im Anschluss daran setzt die Verarbeitungseinheit 10 eine erste Analyselinie 31₂ in dem dritten Fenster auf den Zeitpunkt, der dem Zeitpunkt entspricht, in dem die erste Analyselinie 31₁ in dem ersten Fenster dargestellt ist. Dies gelingt besonders einfach, weil sowohl das erste Teilsignal 2₁ als auch alle weiteren Teilsignale 2₂, 2₃, 2₄ jeweils abschnittsweise berechnet werden, wobei die jeweiligen Abschnitte exakt die gleiche Zeitdauer, insbesondere einen Frame, haben.

Fig. 7A zeigt ein Flussdiagramm eines Ausführungsbeispiels des erfindungsgemäßen Verfahrens, das einen Analysebereich 40 beschreibt. Hierzu wird der Verfahrensschritt S₆ ausgeführt. Innerhalb des Verfahrensschritts S₆ wird ein erster Analysebereich 44₁ anstatt einer ersten Analyselinie 31₁ oder zusätzlich zu einer ersten Analyselinie 41₁ durch die Verarbeitungseinheit in einem ersten Fenster gesetzt. Gleiches gilt natürlich auch für die weiteren Analyselinien 42₁. Der erste Analysebereich 44₁ erstreckt sich dabei über eine Vielzahl von zeitlich zusammenhängenden Fehler-Werten 40₁, wobei ein erstes Ende 42₁ des ersten Analysebereichs 44₁ aus einem ersten Fehlerwert 40₁ gebildet wird, der einen aus einer Speichereinheit 16 geladenen Schwellwert überschreitet. Ein zweites Ende 43₁ des ersten Analysebereichs 44₁ wird aus einem weiteren Fehler-Wert 40₁ gebildet, der einen aus einer Speichereinheit 16 geladenen Schwellwert überschreitet. Zwischen dem ersten Ende 42₁ und dem zweiten Ende 43₁ des Analysebereichs 44₁ liegen ausschließlich Fehler-Werte 40₁, die alle den aus einer Speichereinheit 16 geladenen Schwellwert überschreiten.

Die Verarbeitungseinheit 10 prüft, ob ein zeitlich dem ersten Fehler-Wert vorangegangener Fehler-Wert den Schwellwert nicht mehr überschreitet und stellt dadurch den Beginn des ersten Endes 42₁ fest. Ebenso prüft die Verarbeitungseinheit 10, ob ein dem weiteren Fehler-Wert folgender Fehler-Wert den geladenen Schwellwert überschreitet. Überschreitet der nachfolgende Fehler-Wert den Schwellwert im Gegensatz zu dem weiteren Fehler-Wert nicht mehr, dann bildet der weitere Fehler-Wert das zweite Ende 43₁ des ersten Analysebereichs 44₁. Der erste Analysebereich 44₁ wird bevorzugt in einer Farbe und/oder in einem Kontrast dargestellt, der sich von den bisherigen Farben und/oder Kontrasten auf dem ersten Fenster unterscheidet. Der Kontrast des ersten Analysebereichs 44₁ ist bevorzugt geringer als der des Verlaufs der Fehler-Werte 40₁, allerdings höher als der der Rasterung oder der des Hintergrunds des ersten Fensters.

Fig. 7B zeigt ein Flussdiagramm eines Ausführungsbeispiels des erfindungsgemäßen Verfahrens, das beschreibt, wann der Analysebereich 44₁ gezeichnet wird. Hierzu wird der Verfahrensschritt S_{6_1} möglichst innerhalb des Verfahrensschritts S₆ ausgeführt. Innerhalb des Verfahrensschritts S₆, wird der erste Analysebereich 44₁ anstatt einer ersten Analyselinie 31₁ oder zusätzlich zu einer ersten Analyselinie 41₁ dann gezeichnet, wenn die Verarbeitungseinheit 10 erkennt, dass die Fehler-Werte 30, die zwischen dem ersten Ende 42₁ und dem zweiten Ende 43₁ des zu zeichnenden Analysebereichs 44₁ liegen, eine in der Speichehreinheit 16 gespeicherte Anzahl überschreitet. Es bleibt festzuhalten, dass der erste Analysebereich 44₁ in dem ersten Fenster alleine oder zusätzlich zu der einen Analyselinie 41₁ und/oder den weiteren Analyselinien 42₁ eingezeichnet werden kann. Wird die gespeicherte Anzahl nicht überschritten, so wird maximal nur eine Analyselinie 41₁, 42₁ gezeichnet.

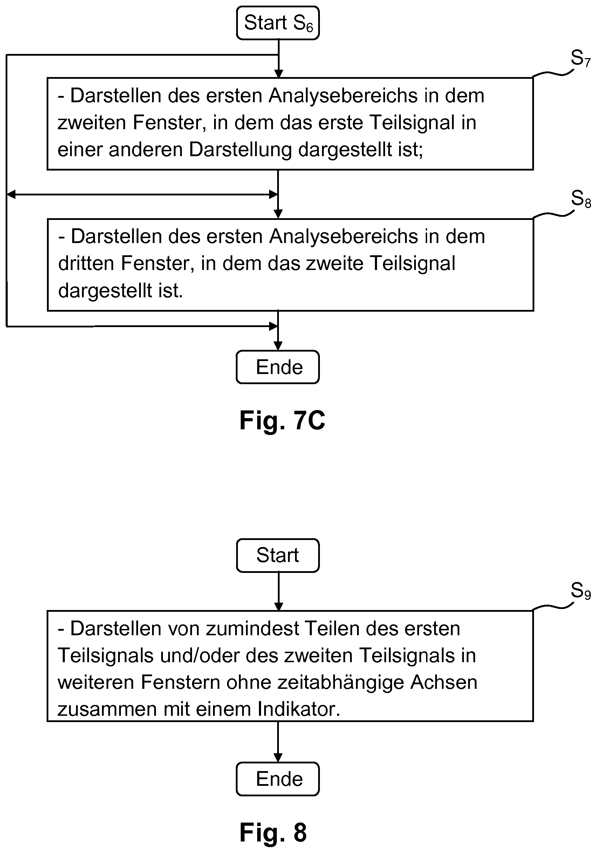

Fig. 7C zeigt ein Flussdiagramm eines Ausführungsbeispiels des erfindungsgemäßen Verfahrens, das beschreibt, wie der Analysebereich 44₂ auch in anderen Fenstern auf einen exakten Zeitbereich gesetzt wird. Hierzu kann nach dem Verfahrensschritt S₆ oder dem Verfahrensschritt S_{6_1} der Verfahrensschritt S₇ ausgeführt werden. Innerhalb des Verfahrensschritt S₇ berechnet eine Verarbeitungseinheit 10 einen Verlauf der Leistung 40₂ von dem ersten Teilsignal und stellt diesen Verlauf in einem zweiten Fenster auf der Anzeigevorrichtung 22 dar. Im Anschluss daran setzt die Verarbeitungseinheit 10 einen ersten Analysebereich 44₂ in dem zweiten Fester auf den Zeitbereich, der dem Zeitbereich entspricht, in dem der erste Analysebereich 44₁ in dem ersten Fenster dargestellt ist.

Zusätzlich und alternativ zu dem Verfahrensschritt S₇ kann der Verfahrensschritt S₈ ausgeführt werden. Innerhalb des Verfahrensschritts S₈ berechnet die Verarbeitungseinheit 10 den Verlauf der Leistung 40₃n dem zweiten Teilsignal 2₂ und stellt diesen Verlauf in einem dritten Fenster auf der Anzeigevorrichtung 22 dar. Die Verarbeitungseinheit 10 setzt einen ersten Analysebereich 44₃ in dem dritten Fenster auf den Zeitbereich, der dem Zeitbereich entspricht, in dem der erste Analysebereich 40 in dem ersten Fenster dargestellt ist.

Fig. 8 zeigt ein Flussdiagramm eines Ausführungsbeispiels des erfindungsgemäßen Verfahrens, das einen Indikator 37₄ beschreibt, der eine Analyselinie und/oder einen Analysebereich in Diagrammen ohne zeitabhängige Achse ersetzt. Hierzu wird der Verfahrensschritt Sg ausgeführt. Innerhalb des Verfahrensschritt Sg stellt eine Verarbeitungseinheit 10 zumindest Teile 30₄ des ersten Teilsignals 2₁ und/oder des zweiten Teilsignals 2₂ in weiteren Fenstern dar, wobei keine zeitabhängigen Achsen innerhalb dieser Fenster vorhanden sind. Die Verarbeitungseinheit 10 stellt weiterhin einen Indikator 37₄ insbesondere in Form eines Symbols oder eines Buchstabenkürzels innerhalb der weiteren Fenster dar. Dieser Indikator 37₄ signalisiert, dass in die Darstellung der Fehler-Wert 30₁ einfließt, auf dem in dem ersten Fenster eine Analyselinie 31₁ gesetzt ist. Ein solcher Indikator kann auch dann in dem weitern Fenster dargestellt werden, wenn in die Darstellung der Fehler-Wert 30₁ einfließt, auf dem in dem ersten Fenster ein Analysebereich 44₁ oder eine weitere Analyselinie 42₁ gesetzt ist.

Insgesamt können unterschiedliche Teilsignale 2₁, 2₂, 2₃, 2₄ in unterschiedlichen Fenstern dargestellt werden, wobei eine in einem Fenster gesetzte Analyselinie 31₁ 41₁ bzw. Analysebereich 44₁ in allen weiteren Fenstern denselben Zeitpunkt bzw. Zeitbereich markieren wie in dem einen Fenster, in dem sie gesetzt sind, sofern die weiteren Fenster eine zeitabhängige Achse haben.

Zusätzlich zu der Analyselinie 31₁, 41₁ oder dem Analysebereich 44₁ können auch diejenigen Fehler-Werte 30₁ im ersten Fenster, die den Schwellwert überschreiten und/oder denen eine Analyselinie 31₁, 41₁ oder ein Analysebereich 44₁ zugewiesen ist gegenüber den restlichen Fehler-Werten 30₁ in einer anderen Farbe dargestellt werden, sodass ein Benutzer die Fehler-Werte 30₁ sofort erkennt, die den Schwellwert überschreiten. Im Gegensatz dazu können je nach gewählter Darstellung in den anderen Fenstern auch die anderen Signalanteile in dergleichen Farbe dargestellt werden, die zu den Zeitpunkten korrespondieren, in denen die Fehler-Werte 30₁ in dem ersten Fenster den Schwellwert überschreiten.

Im Rahmen der Erfindung sind alle beschriebenen und/oder gezeichneten Merkmale beliebig miteinander kombinierbar. Insbesondere können die Unteransprüche das Verfahren betreffend auch mit den Vorrichtungsansprüchen das Messgerät betreffend und umgekehrt kombiniert werden.

## Patentansprüche

1. Messgerät (12) mit einer Speichereinheit (16), einer Verarbeitungseinheit (10) und einer Anzeigevorrichtung (22) zur Darstellung eines digitalisierten und gespeicherten ersten Teilsignals (2₁) und zumindest eines digitalisierten und gespeicherten zweiten Teilsignals (2₂) wobei das erste Teilsignal (2₁) und das zweite Teilsignal (2₂) Teilsignale unterschiedlicher Bänder eines Multibandsignals (1) sind,
wobei die Verarbeitungseinheit (10) ausgebildet ist, um
- ein von dem ersten Teilsignal (2₁) abgeleitetes erstes Signal (30₁) und eine erste Analyselinie (31₁, 41₁) in einem ersten Fenster auf der Anzeigevorrichtung (22) darzustellen, und
- ein von dem zweiten Teilsignal abgeleitetes zweites Signal (30₂, 40₂) und eine zeitlich der ersten Analyselinie (31₁, 41₁) des ersten Fensters entsprechende erste Analyselinie (31₂, 41₂) in einem zweiten Fenster auf der Anzeigevorrichtung (22) darzustellen,
wobei die Verarbeitungseinheit (10) von dem ersten Teilsignal (2₁) den Verlauf eines Fehler-Werts (30₁, 40₁) über einen bestimmten Zeitraum berechnet und ihn als erstes Signal (30₁, 40₁) in einem ersten Fenster auf der Anzeigevorrichtung (22) darstellt, und
wobei die Verarbeitungseinheit (10) in dem ersten Fenster die erste Analyselinie (31₁, 41₁) auf den Zeitpunkt setzt, an dem der Verlauf des Fehler-Werts (30₁) einen durch die Verarbeitungseinheit (22) aus einer Speichereinheit (16) geladenen Schwellwert überschreitet.

2. Messgerät nach Anspruch 1,
**dadurch gekennzeichnet,**
**dass** die Verarbeitungseinheit (10) die erste Analyselinie (41₁) im ersten Fenster auf den ersten Zeitpunkt setzt, an dem der Fehler-Wert (40₁) den aus einer Speichereinheit (16) geladenen Schwellwert überschreitet und/oder dass die Verarbeitungseinheit (10) die erste Analyselinie (41₁) im ersten Fenster auf den Zeitpunkt setzt, an dem der Fehler-Wert (40₁) am höchsten ist und den aus einer Speichereinheit (16) geladenen Schwellwert überschreitet und/oder
**dass** die Verarbeitungseinheit (10) weitere Analyselinien (42₁) im ersten Fenster auf weitere Zeitpunkte setzt, an denen die Fehler-Werte (40₁) den aus einer Speichereinheit (16) geladenen Schwellwert überschreiten.

3. Messgerät nach Anspruch 1 oder 2,
**dadurch gekennzeichnet,**
**dass** die Verarbeitungseinheit (10) von dem ersten Teilsignal (2₁) einen Verlauf der Leistung (30₂, 40₂) berechnet und in dem zweiten Fenster auf der Anzeigevorrichtung (22) darstellt, und
**dass** die Verarbeitungseinheit (10) eine erste Analyselinie (31₂, 41₂) in dem zweiten Fenster auf den Zeitpunkt setzt, der dem Zeitpunkt entspricht, in dem die erste Analyselinie (31₁, 41₁) in dem ersten Fenster dargestellt ist und/oder
**dass** die Verarbeitungseinheit (10) von dem zweiten Teilsignal (2₂) einen Verlauf der Leistung (40₂) berechnet und in einem dritten Fenster auf der Anzeigevorrichtung (22) darstellt und dass die Verarbeitungseinheit (10) eine erste Analyselinie (41₂) in dem dritten Fenster auf den Zeitpunkt setzt, der dem Zeitpunkt entspricht, in dem die erste Analyselinie (41₁) in dem ersten Fenster dargestellt ist.

4. Messgerät nach einem der Ansprüche 1 bis 3,
**dadurch gekennzeichnet,**
**dass** die Verarbeitungseinheit (10) zusätzlich zu einer ersten Analyselinie (41₁) im ersten Fenster einen ersten Analysebereich (44₁) zeichnet, der sich über eine Vielzahl von zeitlich zusammenhängenden Fehler-Werten (40₂) erstreckt, wobei ein erster Fehler-Wert, der einen aus einer Speichereinheit (16) geladenen Schwellwert überschreitet ein erstes Ende (42₁) des Analysebereichs (44₁) bildet, wobei ein weiterer Fehler-Wert, der einen aus einer Speichereinheit (16) geladenen Schwellwert überschreitet, ein zweites Ende (43₁) des Analysebereichs (44₁) darstellt und wobei die zwischen dem ersten Ende (42₁) und dem zweiten Ende (43₁) des Analysebereichs (44₁) liegenden Fehler-Werte alle den aus einer Speichereinheit (16) geladenen Schwellwert überschreiten.

5. Messgerät nach Anspruch 4,
**dadurch gekennzeichnet,**
**dass** die Verarbeitungseinheit (10) einen ersten Analysebereich (44₁) zeichnet, wenn die Fehler-Werte, die zwischen dem ersten Ende (42₁) und dem zweiten Ende (43₁) des zu zeichnenden Analysebereichs (44₁) liegen, eine in der Speichereinheit (16) gespeicherte Anzahl überschreiten.

6. Messgerät nach Anspruch 2 oder 3,
**dadurch gekennzeichnet,**
**dass** die Verarbeitungseinheit (10) von dem ersten Teilsignal (2₁) einen Verlauf der Leistung (40₂) berechnet und in dem zweiten Fenster auf der Anzeigevorrichtung (22) darstellt und dass die Verarbeitungseinheit (10) einen ersten Analysebereich (44₂) in dem zweiten Fenster auf den Zeitbereich setzt, der dem Zeitbereich entspricht, in dem der erste Analysebereich (44₁) in dem ersten Fenster dargestellt ist und/oder
**dass** die Verarbeitungseinheit (10) von dem zweiten Teilsignal (2₂) einen Verlauf der Leistung berechnet (40₃) und in einem dritten Fenster auf der Anzeigevorrichtung (22) darstellt und dass die Verarbeitungseinheit (10) einen ersten Analysebereich (44₃) in dem dritten Fenster auf den Zeitbereich setzt, der dem Zeitbereich entspricht, in dem der erste Analysebereich (44₁) in dem ersten Fenster dargestellt ist.

7. Messgerät nach einem der vorherigen Ansprüche,
**dadurch gekennzeichnet,**
**dass** die Verarbeitungseinheit (10) zumindest Teile des ersten Teilsignals (2₁) und/oder des zweiten Teilsignals (2₂) in weiteren Fenstern darstellt, wobei die Darstellung keine zeitabhängige Achse enthält, wobei ein Indikator (37), insbesondere in Form eines Symbols oder Buchstabenkürzels, innerhalb der weiteren Fenster signalisiert, dass in die Darstellung des Fehler-Werts einfließt auf den die Verarbeitungseinheit (10) in dem ersten Fenster eine erste Analyselinie (31₁, 41₁) setzt.

8. Messgerät nach einem der vorherigen Ansprüche,
**dadurch gekennzeichnet,**
**dass** sich bei dem ersten Teilsignal (2₁) um ein WCDMA-Signal handelt und/oder dass es sich bei dem Fehler-Wert (30₁, 40₁) um einen EVM-Wert (30₁, 40₁) handelt und dass in dem ersten Fenster der Verlauf des EVM-Werts (30₁, 40₁) über verschiedene Chips aufgetragen ist und/oder dass in dem zweiten Fenster die Leistung über die Slots (30₂, 40₂) aufgetragen ist und/oder das in dem zweiten Fenster die Leistung der Code-Domäne aufgetragen ist und/oder
**dass** es sich bei dem zweiten Teilsignal (2₂) um ein TDMA-Signal, insbesondere um ein GSM-Signal, handelt und/oder dass in dem dritten Fenster die Leistung (30₃, 40₃) des zweiten Teilsignals (2₂) in der Zeitdomäne aufgetragen ist.

9. Verfahren zur Darstellung eines digitalisierten und gespeicherten ersten Teilsignals (2₁) und zumindest eines digitalisierten und gespeicherten zweiten Teilsignals (2₂) eines Multibandsignals (1) auf einer Anzeigevorrichtung (22) mit den folgenden Verfahrensschritten:
- Berechnen (S₁) eines ersten Signals (30₁, 40₁), welches von dem ersten Teilsignal (2₁) abgeleitet ist;
- Darstellen (S₂) des ersten Signals (30₁, 40₁) und einer ersten Analyselinie (31₁, 41₁) in einem ersten Fenster auf der Anzeigevorrichtung (22);
- Berechnen (S₄) eines zweiten Signals (30₂, 40₂), welches von dem zweiten Teilsignal (2₂) abgeleitet ist;
- Darstellen (S₅) des zweiten Signals (30₂, 40₂) und einer zeitlich der ersten Analyselinie (31₁, 41₁) des ersten Fensters entsprechenden ersten Analyselinie (31₂, 41₂) in einem zweiten Fenster auf der Anzeigevorrichtung (22),
wobei das erste Signal (30₁, 40₁) ein Verlauf eines Fehler-Werts (30₁, 40₁) von dem ersten Teilsignal (2₁) über einen bestimmten Zeitraum ist, und
wobei die ersten Analyselinie (31₁, 41₁) auf den Zeitpunkt gesetzt wird, an dem der Verlauf des Fehler-Werts (30₁, 40₁) einen vorgegebenen Schwellwert überschreitet.

10. Verfahren nach Anspruch 9,
**gekennzeichnet durch,**
folgende Verfahrensschritte:
- Setzen (S_{3_1}) der ersten Analyselinie (31₁, 41₁) im ersten Fenster auf den ersten Zeitpunkt, an dem der Fehler-Wert (30₁, 40₁) den Schwellwert überschreitet; und/oder
- Setzen (S_{3_2}) der ersten Analyselinie (31₁, 41₁) im ersten Fenster auf den Zeitpunkt, an dem der Fehler-Wert (30₁, 40₁) am höchsten ist und den Schwellwert überschreitet; und/oder
- Setzen (S_{3_3}) weiterer Analyselinien (42₁) im ersten Fenster auf weitere Zeitpunkte, an denen die Fehler-Werte (30₁, 40₁) den Schwellwert überschreiten.

11. Verfahren nach Anspruch 9 oder 10,
**gekennzeichnet durch,**
folgende Verfahrensschritte:
- Berechnen (S₄) eines Verlaufs der Leistung (30₂, 40₂) von dem ersten Teilsignal (2₁) und Darstellen des Verlaufs (30₂, 40₂) in einem zweiten Fenster auf der Anzeigevorrichtung (22) und Setzen einer ersten Analyselinie (31₁, 41₁) in dem zweiten Fenster auf den Zeitpunkt, der dem Zeitpunkt entspricht, in dem die erste Analyselinie (31₁, 41₁) in dem ersten Fenster dargestellt ist; und/oder
- Berechnen (S₅) eines Verlaufs der Leistung (30₃, 40₃) von dem zweiten Teilsignal (2₂) und Darstellen des Verlaufs (30₃, 40₃) in einem dritten Fenster auf der Anzeigevorrichtung (22) und Setzen einer ersten Analyselinie (31₃, 41₃) in dem dritten Fenster auf den Zeitpunkt, der dem Zeitpunkt entspricht, in dem die erste Analyselinie (31₁, 41₁) in dem ersten Fenster dargestellt ist.

12. Verfahren nach einem der Ansprüche 9 bis 11,
**gekennzeichnet durch,**
folgende Verfahrensschritte:
- Zeichnen (S₆) eines ersten Analysebereichs (44₁) zusätzlich zu einer ersten Analyselinie (41₁) im ersten Fenster, der sich über eine Vielzahl von zeitlich zusammenhängenden Fehler-Werten (40₁) erstreckt und Bilden eines ersten Endes (42₁) des ersten Analysebereichs (44₁) aus einem ersten Fehler-Wert, der einen Schwellwert überschreitet und Bilden eines zweiten Ende (43₁) des ersten Analysebereichs (44₁) aus einem weiteren Fehler-Wert, der einen Schwellwert überschreitet, wobei die zwischen dem ersten Ende (42₁) und dem zweiten Ende (43₁) des ersten Analysebereichs (44₁) liegenden Fehler-Werte alle den Schwellwert überschreiten.

13. Verfahren nach Anspruch 12,
**gekennzeichnet durch,**
folgende Verfahrensschritte:
- Zeichnen (S_{6_1}) des ersten Analysebereichs (44₁) zusätzlich zu einer ersten Analyselinie (41₁), wenn erkannt wird, dass die Fehler-Werte, die zwischen dem ersten Ende (42₁) und dem zweiten Ende (43₁) des zu zeichnenden ersten Analysebereichs (44₁) liegen, eine gespeicherte Anzahl überschreiten.

14. Verfahren nach Anspruch 12 oder 13,
**gekennzeichnet durch,**
folgende Verfahrensschritte:
- Berechnen (S₇) eines Verlaufs der Leistung (30₂, 40₂) von dem ersten Teilsignal (2₁) und Darstellen des Verlaufs in einem zweiten Fenster auf der Anzeigevorrichtung (22) und Setzen eines ersten Analysebereichs (44₂) in dem zweiten Fenster auf den Zeitbereich, der dem Zeitbereich entspricht, in dem der erste Analysebereich (44₁) in dem ersten Fenster dargestellt ist; und/oder
- Berechnen (S₈) eines Verlaufs der Leistung (30₃, 40₃) von dem zweiten Teilsignal (2₂) und Darstellen des Verlaufs (30₃, 40₃) in einem dritten Fenster auf der Anzeigevorrichtung (22) und Setzen eines ersten Analysebereichs (44₃) in dem dritten Fenster auf den Zeitbereich, der dem Zeitbereich entspricht, in dem der erste Analysebereich (44₁) in dem ersten Fenster dargestellt ist.

15. Verfahren nach einem der Ansprüche 9 bis 14,
**gekennzeichnet durch,**
- Darstellen (S₉) von zumindest Teilen des ersten Teilsignals (2₁) und/oder des zweiten Teilsignals (2₂) in weiteren Fenstern, wobei keine zeitabhängigen Achsen dargestellt werden, wobei ein Indikator (37), insbesondere in Form eines Symbols oder Buchstabenkürzels, innerhalb der weiteren Fenster dargestellt ist, der signalisiert, dass in die Darstellung der Fehler-Wert einfließt auf den in dem ersten Fenster eine erste Analyselinie (31₁) gesetzt wird.

16. Computerprogramm mit Programmcode-Mitteln, um alle Schritte gemäß einem der Ansprüche 9 bis 15 durchführen zu können, wenn das Programm auf einem Computer oder einem digitalen Signalprozessor ausgeführt wird.

17. Computerprogramm-Produkt mit auf einem maschinenlesbaren Träger gespeicherten Programmcode-Mitteln, um alle Schritte gemäß einem der Ansprüche 9 bis 15 durchführen zu können, wenn das Programm auf einem Computer oder einem digitalen Signalprozessor ausgeführt wird.

## Claims

1. A measuring device (12) with a storage unit (16), a processing unit (10) and a display device (22) for displaying a digitized and stored first partial signal (2₁) and at least one digitized and stored second partial signal (2₂), wherein the first partial signal (2₁) and the second partial signal (2₂) are partial signals of different bands of a multiband signal (1),
wherein the processing unit (10) is configured to display
- a first signal (30₁) derived from the first partial signal (2₁) and a first analysis line (31₁, 41₁) in a window on the display device (22), and
- a second signal (30₂, 40₂) derived from the second partial signal and a first analysis line (31₂, 41₂) corresponding temporally to the first analysis line (31₁, 41₁) of the first window in a second window on the display device (2₂) ,
wherein the processing unit (10) calculates the characteristic of an error value (30₁, 40₁) over a specified period of time from the first partial signal (2₁) and displays it as a first signal (30₁, 40₁) in a first window on the display device (22), and
wherein the processing unit (10) sets the first analysis line (31₁, 41₁) in the first window to the point in time at which the characteristic of the error value (30₁) exceeds a threshold value loaded by the processing unit (10) from a storage unit (16).

2. The measuring device according to claim 1,
**characterized in**
**that** the processing unit (10) sets the first analysis line (41₁) in the first window to the first point in time at which the error value (40₁) exceeds the threshold value loaded from a storage unit (16) and/or
**that** the processing unit (10) sets the first analysis line (41₁) in the first window to the point in time at which the error value (40₁) is highest and exceeds the threshold value loaded from a storage unit (16) and/or
**that** the processing unit (10) sets further analysis lines (42₁) in the first window to further points in time at which the error values (40₁) exceed the threshold value loaded from a storage unit (16).

3. The measuring device according to claim 1 or 2,
**characterized in**
**that** the processing unit (10) calculates a characteristic of the performance (30₂, 40₂) from the first partial signal (2₁) and displays it in a second window on the display device (22), and,
**that** the processing unit (10) sets a first analysis line (31₂, 41₂) in the second window to the point in time corresponding to the point in time in which the first analysis line (31₁, 41₁) is displayed in the first window and/or
**that** the processing unit (10) calculates a characteristic of the performance (40₂) from the second partial signal (2₂) and displays it in a third window on the display device (22), and in that the processing unit (10) sets a first analysis line (41₂) in the third window to the point in time corresponding to the point in time in which the first analysis line (41₁) is displayed in the first window.

4. The measuring device according to claim 1 to 3,
**characterized in**
**that** the processing unit (10) plots a first analysis range (44₁) in the first window in addition to a first analysis line (41₁), which extends over a plurality of temporally coherent error values (40₂), wherein a first error value, which exceeds a threshold value loaded from a storage unit (16) forms a first end (42₁) of the analysis range (44₁), wherein a further error value, which exceeds a threshold value loaded from a storage unit (16), represents a second end (43₁) of the analysis range (44₁) and wherein the error values lying between the first end (42₁) and the second end (43₁) of the analysis range (44₁) all exceed the threshold value loaded from a storage unit (16).

5. The measuring device according to claim 4,
**characterized in**
**that** the processing unit (10) plots a first analysis range (44₁) when the error values which lie between the first end (42₁) and the second end (43₁) of the analysis range (44₁) to be plotted exceed a number stored in the storage unit (16).

6. The measuring device according to claim 2 or 3,
**characterized in**
**that** the processing unit (10) calculates a characteristic of the performance (40₂) from the first partial signal (2₁) and displays it in the second window on the display device (22) and in that the processing unit (10) sets a first analysis range (44₂) in the second window to the time range which corresponds to the time range in which the first analysis range (44₁) is displayed in the first window and/or
**that** the processing unit (10) calculates a characteristic of the performance (40₃) from the second partial signal (2₂) and displays it in a third window on the display device (22) and that the processing unit (10) sets a first analysis range (44₃) in the third window to the time range that corresponds to the time range in which the first analysis range (44₁) is displayed in the first window.

7. The measuring device according to any of the preceding claims,
**characterized in**
**that** the processing unit (10) displays at least parts of the first partial signal (2₁) and/or of the second partial signal (2₂) in further windows, wherein the display does not contain any time-dependent axis, wherein an indicator (37), in particular in the form of an icon or letter abbreviation, within the further windows signals that of the error value, at which the processing unit (10) inserts a first analysis line (31₁, 41₁) in the first window, flows into the display.

8. The measuring device according to any of the preceding claims,
**characterized in**
**that** the first partial signal (2₁) is a WCDMA signal and/or that the error value (30₁, 40₁) is an EVM value (30₁, 40₁) and that the characteristic of the EVM value (30₁, 40₁) is plotted via different chips in the first window and/or that the performance is plotted via the slots (30₂, 40₂) in the second window and/or that the performance of the code domains is plotted in the second window and/or
**that** the second partial signal (2₂) is a TDMA signal, in particular a GSM signal, and/or in that the performance (30₃, 40₃) of the second partial signal (2₂) is plotted in the time domain in the third window.

9. A method for displaying a digitized and stored first partial signal (2₁) and at least one digitized and stored second partial signal (2₂) of a multiband signal (1) on a display device (22) having the following method steps:
- calculating (S₁) a first signal (30₁, 40₁), which is derived from the first partial signal (2₁);
- displaying (S₂) the first signal (30₁, 40₁) and a first analysis line (31₁, 41₁) in a first window on the display device (22);
- calculating (S₄) a second signal (30₂, 40₂), which is derived from the second partial signal (2₂);
- displaying (S₅) the second signal (30₂, 40₂) and a first analysis line (31₂, 41₂) corresponding temporally to the first analysis line (31₁, 41₁) of the first window in a second window in the display device (22),
wherein the first signal (30₁, 40₁) is a characteristic of an error value (30₁, 40₁) of the first partial signal (2₁) over a specified period of time, and
wherein the first analysis line (31₁, 41₁) is set to the point in time at which the characteristic of the error value (30₁, 40₁) exceeds a predefined threshold value.

10. The method according to claim 9,
**characterized by**
the following method steps:
- setting (S_{3_1}) the first analysis line (31₁, 41₁) in the first window to the first point in time at which the error value (30₁, 40₁) exceeds the threshold value; and/or
- setting (S_{3_2}) the first analysis line (31₁, 41₁) in the first window to the point in time at which the error value (30₁, 40₁) is highest and exceeds the threshold value; and/or
- setting (S_{3_3}) further analysis lines (42₁) in the first window to further points in time at which the error values (30₁, 40₁) exceed the threshold value.

11. The method according to claim 9 or 10,
**characterized by**
the following method steps:
- calculating (S₄) a characteristic of the performance (30₂, 40₂) of the first partial signal (2₁) and displaying the characteristic (30₂, 40₂) in a second window on the display device (22) and setting a first analysis line (31₁, 41₁) in the second window to the point in time that corresponds to the point in time in which the first analysis line (31₁, 41₁) is displayed in the first window; and/or
- calculating (S₅) a characteristic of the performance (30₃, 40₃) of the second partial signal (2₂) and displaying the characteristic (30₃, 40₃) in a third window on the display device (22) and setting a first analysis line (31₃, 41₃) in the third window to the point in time that corresponds to the point in time in which the first analysis line (31₁, 41₁) is displayed in the first window.

12. The method according to any of claims 9 to 11,
**characterized by**
the following method steps:
- plotting (S₆) of a first analysis range (44₁) in addition to a first analysis line (41₁) in the first window, which extends over a plurality temporally coherent error values (40₁) and forming a first end (42₁) of the first analysis range (44₁) from a first error value, which exceeds a threshold value and forming a second end (43₁) of the first analysis range (44₁) from a further error value, which exceeds a threshold value, wherein the error values lying between the first end (42₁) and the second end (43₁) of the first analysis range (44₁) all exceed the threshold value.

13. The method according to claim 12
**characterized by**
the following method steps:
- plotting (S_{6_1}) the first analysis range (44₁) in addition to a first analysis line (41₁) when it is detected that the error values lying between the first end (42₁) and the second end (43₁) of the first analysis range (44₁) to be plotted exceed a stored number.

14. The method according to claim 12 or 13,
**characterized by**
the following method steps:
- calculating (S₇) a characteristic of the performance (30₂, 40₂) from the first partial signal (2₁) and displaying the characteristic in a second window on the display device (22) and setting a first analysis range (44₂) in the second window to the time range corresponding to the time range in which the first analysis range (44₁) is displayed in the first window; and/or
- calculating (S₈) a characteristic of the performance (30₃, 40₃) of the second partial signal (2₂) and displaying the characteristic (30₃, 40₃) in a third window on the display device (22) and setting a first analysis range (44₃) in the third window to the time range corresponding to the time range in which the first analysis range (44₁) is displayed in the first window.

15. The method according to any of claims 9 to 14,
**characterized by**,
- displaying (S₉) at least parts of the first partial signal (2₁) and/or of the second partial signal (2₂) in further windows, wherein no time-dependent axes are displayed, wherein an indicator (37), in particular in the form of an icon or letter abbreviation, within the further windows is displayed, which signals that of the error value, at which a first analysis line (31₁,) is inserted in the first window, flows into the display.

16. A computer program with program code means in order to be able to carry out all of the steps according to any of claims 9 to 15 when the program is being executed on a computer or on a digital signal processor.

17. A computer program product with program code means stored on a machine-readable carrier in order to be able to carry out all of the steps according to any of claims 9 to 15 when the program is being executed on a computer or on a digital signal processor.

## Revendications

1. Appareil de mesure (12) avec une unité mémoire (16), une unité de traitement (10) et un dispositif d'affichage (22) pour représenter un premier signal partiel (2₁) numérisé et mis en mémoire et au moins un deuxième signal partiel (2₂) numérisé et mis en mémoire, dans lequel le premier signal partiel (2₁) et le deuxième signal partiel (2₂) sont des signaux partiels de différentes bandes d'un signal multibande (1),
dans lequel l'unité de traitement (10) est réalisée pour
- représenter un premier signal (30₁) dérivé du premier signal partiel (2₁) et une première ligne d'analyse (31₁, 41₁) dans une première fenêtre sur le dispositif d'affichage (22), et
- représenter un deuxième signal (30₂, 40₂) dérivé du deuxième signal partiel et une première ligne d'analyse (31₂, 41₂) correspondant dans le temps à la première ligne d'analyse (31₁, 41₁) de la première fenêtre dans une deuxième fenêtre sur le dispositif d'affichage (22),
dans lequel l'unité de traitement (10) calcule à partir du premier signal partiel (2₁) la variation d'une valeur d'erreur (30₁, 40₁) pendant une période définie et la représente en tant que premier signal (30₁, 40₁) dans une première fenêtre sur le dispositif d'affichage (22), et
dans lequel l'unité de traitement (10) pose la première ligne d'analyse (31₁, 41₁) dans la première fenêtre au moment où la variation de la valeur d'erreur (30₁) dépasse une valeur seuil chargée par l'unité de traitement (10) à partir d'une unité mémoire (16).

2. Appareil de mesure selon la revendication 1,
**caractérisé en ce**
**que** l'unité de traitement (10) pose la première ligne d'analyse (41₁) dans la première fenêtre au premier moment où la valeur d'erreur (40₁) dépasse la valeur seuil chargée à partir d'une unité mémoire (16) et/ou
**que** l'unité de traitement (10) pose la première ligne d'analyse (41₁) dans la première fenêtre au moment où la valeur d'erreur (40₁) est la plus haute et dépasse la valeur seuil chargée à partir d'une unité mémoire (16) et/ou
**que** l'unité de traitement (10) pose d'autres lignes d'analyse (42₁) dans la première fenêtre à d'autres moments où les valeurs d'erreur (40₁) dépassent la valeur seuil chargée à partir d'une unité mémoire (16).

3. Appareil de mesure selon la revendication 1 ou 2,
**caractérisé en ce**
**que** l'unité de traitement (10) calcule à partir du premier signal partiel (2₁) une variation de la puissance (30₂, 40₂) et la représente dans la deuxième fenêtre sur le dispositif d'affichage (22), et
**que** l'unité de traitement (10) pose une première ligne d'analyse (31₂, 41₂) dans la deuxième fenêtre au moment qui correspond au moment où la première ligne d'analyse (31₁, 41₁) est représentée dans la première fenêtre et/ou
**que** l'unité de traitement (10) calcule à partir du deuxième signal partiel (2₂) une variation de la puissance (40₂) et la représente dans une troisième fenêtre sur le dispositif d'affichage (22) et que l'unité de traitement (10) pose une première ligne d'analyse (41₂) dans la troisième fenêtre au moment qui correspond au moment où la première ligne d'analyse (41₁) est représentée dans la première fenêtre.

4. Appareil de mesure selon l'une quelconque des revendications 1 à 3,
**caractérisé en ce**
**que** l'unité de traitement (10) trace en plus d'une première ligne d'analyse (41₁) dans la première fenêtre une première zone d'analyse (44₁), qui s'étend sur une pluralité de valeurs d'erreur (40₂) cohérentes dans le temps, dans lequel une première valeur d'erreur, qui dépasse une valeur seuil chargée à partir d'une unité mémoire (16), forme une première extrémité (42₁) de la zone d'analyse (44₁), dans lequel une autre valeur d'erreur, qui dépasse une valeur seuil chargée à partir d'une unité mémoire (16), représente une deuxième extrémité (43₁) de la zone d'analyse (44₁) et dans lequel les valeurs d'erreur situées entre la première extrémité (42₁) et la deuxième extrémité (43₁) de la zone d'analyse (44₁) dépassent toutes la valeur seuil chargée à partir d'une unité mémoire (16).

5. Appareil de mesure selon la revendication 4,
**caractérisé en ce**
**que** l'unité de traitement (10) trace une première zone d'analyse (44₁), lorsque les valeurs d'erreur, qui se situent entre la première extrémité (42₁) et la deuxième extrémité (43₁) de la zone d'analyse (44₁) à tracer, dépassent un nombre mis en mémoire dans l'unité mémoire (16).

6. Appareil de mesure selon la revendication 2 ou 3,
**caractérisé en ce**
**que** l'unité de traitement (10) calcule à partir du premier signal partiel (2₁) une variation de la puissance (40₂) et la représente dans la deuxième fenêtre sur le dispositif d'affichage (22) et que l'unité de traitement (10) pose une première zone d'analyse (44₂) dans la deuxième fenêtre sur la plage temporelle qui correspond à la plage temporelle dans laquelle la première zone d'analyse (44₁) est représentée dans la première fenêtre et/ou
**que** l'unité de traitement (10) calcule à partir du deuxième signal partiel (2₂) une variation de la puissance (40₃) et la représente dans une troisième fenêtre sur le dispositif d'affichage (22) et que l'unité de traitement (10) pose une première zone d'analyse (44₃) dans la troisième fenêtre sur la plage temporelle qui correspond à la plage temporelle dans laquelle la première zone d'analyse (44₁) est représentée dans la première fenêtre.

7. Appareil de mesure selon l'une quelconque des revendications précédentes,
**caractérisé en ce**
**que** l'unité de traitement (10) représente au moins des parties du premier signal partiel (2₁) et/ou du deuxième signal partiel (2₂) dans d'autres fenêtres, dans lequel la représentation ne contient pas d'axe dépendant du temps, dans lequel un indicateur (37), en particulier prenant la forme d'un symbole ou d'une abréviation alphabétique, à l'intérieur de l'autre fenêtre signale que de la valeur d'erreur à laquelle l'unité de traitement (10) pose une première ligne d'analyse (31₁, 41₁) dans la première fenêtre circule dans la représentation.

8. Appareil de mesure selon l'une quelconque des revendications précédentes,
**caractérisé en ce**
**que** le premier signal partiel (2₁) est un signal WCDMA et/ou que la valeur d'erreur (30₁, 40₁) est une valeur EVM (30₁, 40₁) et que dans la première fenêtre la variation de la valeur EVM (30₁, 40₁) est appliquée par l'intermédiaire de différentes puces et/ou que dans la deuxième fenêtre la puissance est appliquée par l'intermédiaire des fentes (30₂, 40₂) et/ou que dans la deuxième fenêtre la puissance du domaine de code est appliquée et/ou
**que** le deuxième signal partiel (2₂) est un signal TDMA, en particulier un signal GSM et/ou
**que** dans la troisième fenêtre la puissance (30₃, 40₃) du deuxième signal partiel (2₂) est appliquée dans le domaine temporel.

9. Procédé pour représenter un premier signal partiel (2₁) numérisé et mis en mémoire et au moins un deuxième signal partiel (2₂) numérisé et mis en mémoire d'un signal multibande (1) sur un dispositif d'affichage (22) avec les étapes de procédé suivantes :
- le calcul (S₁) d'un premier signal (30₁, 40₁), lequel est dérivé du premier signal partiel (2₁) ;
- la représentation (S₂) du premier signal (30₁, 40₁) et d'une première ligne d'analyse (31₁, 41₁) dans une première fenêtre sur le dispositif d'affichage (22) ;
- le calcul (S₄) d'un deuxième signal (30₂, 40₂), lequel est dérivé du deuxième signal partiel (2₂) ;
- la représentation (S₅) du deuxième signal (30₂, 40₂) et d'une première ligne d'analyse (31₂, 41₂) correspondant dans le temps à la première ligne d'analyse (31₁, 41₁) de la première fenêtre dans une deuxième fenêtre sur le dispositif d'affichage (22),
dans lequel le premier signal (30₁, 40₁) est une variation d'une valeur d'erreur (30₁, 40₁) à partir du premier signal partiel (2₁) pendant une période définie, et
dans lequel la première ligne d'analyse (31₁, 41₁) est posée au moment où la variation de la valeur d'erreur (30₁, 40₁) dépasse une valeur seuil prédéfinie.

10. Procédé selon la revendication 9,
**caractérisé par**
les étapes suivantes :
- la pose (S_{3_1}) de la première ligne d'analyse (31₁, 41₁) dans la première fenêtre au premier moment où la valeur d'erreur (30₁, 40₁) dépasse la valeur seuil ; et/ou
- la pose (S_{3_2}) de la première ligne d'analyse (31₁, 41₁) dans la première fenêtre au moment où la valeur d'erreur (30₁, 40₁) est la plus haute et dépasse la valeur seuil ; et/ou
- la pose (S_{3_3}) d'autres lignes d'analyse (42₁) dans la première fenêtre à d'autres moments où les valeurs d'erreur (30₁, 40₁) dépassent la valeur seuil.

11. Procédé selon la revendication 9 ou 10,
**caractérisé par**
les étapes de procédé suivantes :
- le calcul (S₄) d'une variation de la puissance (30₂, 40₂) à partir du premier signal partiel (2₁) et la représentation de la variation (30₂, 40₂) dans une deuxième fenêtre sur le dispositif d'affichage (22) et la pose d'une première ligne d'analyse (31₁, 41₁) dans la deuxième fenêtre au moment qui correspond au moment où la première ligne d'analyse (31₁, 41₁) est représentée dans la première fenêtre ; et/ou
- le calcul (S₅) d'une variation de la puissance (30₃, 40₃) à partir du deuxième signal partiel (2₂) et la représentation de la variation (30₃, 40₃) dans une troisième fenêtre sur le dispositif d'affichage (22) et la pose d'une première ligne d'analyse (31₃, 41₃) dans la troisième fenêtre au moment qui correspond au moment où la première ligne d'analyse (31₁, 41₁) est représentée dans la première fenêtre.

12. Procédé selon l'une quelconque des revendications 9 à 11,
**caractérisé par**
les étapes de procédé suivantes :
- le tracé (S₆) d'une première zone d'analyse (44₁) en plus d'une première ligne d'analyse (41₁) dans la première fenêtre, qui s'étend sur une pluralité de valeurs d'erreur (40₁) cohérentes dans le temps et la formation d'une première extrémité (42₁) de la première zone d'analyse (44₁) à partir d'une première valeur d'erreur, qui dépasse une valeur seuil et la formation d'une deuxième extrémité (43₁) de la première zone d'analyse (44₁) à partir d'une autre valeur d'erreur, qui dépasse une valeur seuil, dans lequel les valeurs d'erreur situées entre la première extrémité (42₁) et la deuxième extrémité (43₁) de la première zone d'analyse (44₁) dépassent toutes la valeur seuil.

13. Procédé selon la revendication 12,
**caractérisé par**
les étapes de procédé suivantes :
- le tracé (S_{6_1}) de la première zone d'analyse (44₁) en plus d'une première ligne d'analyse (41₁), lorsqu'il est reconnu que les valeurs d'erreur, qui se situent entre la première extrémité (42₁) et la deuxième extrémité (43₁) de la première zone d'analyse (44₁) à tracer, dépassent un nombre mis en mémoire.

14. Procédé selon la revendication 12 ou 13,
**caractérisé par**
les étapes de procédé suivantes :
- le calcul (S₇) d'une variation de la puissance (30₂, 40₂) à partir du premier signal partiel (2₁) et la représentation de la variation dans une deuxième fenêtre sur le dispositif d'affichage (22) et la pose d'une première zone d'analyse (44₂) dans la deuxième fenêtre sur la plage temporelle qui correspond à la plage temporelle dans laquelle la première zone d'analyse (44₁) est représentée dans la première fenêtre ; et/ou
- le calcul (S₈) d'une variation de la puissance (30₃, 40₃) à partir du deuxième signal partiel (2₂) et la représentation de la variation (30₃, 40₃) dans une troisième fenêtre sur le dispositif d'affichage (22) et la pose d'une première zone d'analyse (44₃) dans la troisième fenêtre sur la plage temporelle qui correspond à la plage temporelle dans laquelle la première ligne d'analyse (44₁) est représentée dans la première fenêtre.

15. Procédé selon l'une quelconque des revendications 9 à 14,
**caractérisé par**
- la représentation (S₉) d'au moins des parties du premier signal partiel (2₁) et/ou du deuxième signal partiel (2₂) dans d'autres fenêtres, dans lequel aucun axe dépendant du temps n'est représenté, dans lequel un indicateur (37), en particulier prenant la forme d'un symbole ou d'une abréviation alphabétique, est représenté à l'intérieur de l'autre fenêtre, qui signale que la valeur d'erreur, à laquelle une première ligne d'analyse (31₁) est posée dans la première fenêtre, circule dans la représentation.

16. Programme informatique avec des moyens formant code de programme, afin de pouvoir réaliser toutes les étapes selon l'une quelconque des revendications 9 à 15, lorsque le programme est réalisé sur un ordinateur ou un processeur de signal numérique.

17. Produit-programme informatique avec des moyens formant code de programme mis en mémoire sur un support lisible par machine, afin de pouvoir réaliser toutes les étapes selon l'une quelconque des revendications 9 à 15, lorsque le programme est exécuté sur un ordinateur ou un processeur de signal numérique.
